(19) Europäisches Patentamt

European Patent Office

Office européen des brevets

(11) **EP 1 192 570 B1**

(12) **EUROPEAN PATENT SPECIFICATION**

(45) Date of publication and mention
of the grant of the patent:
**16.11.2005 Bulletin 2005/46**

(51) Int Cl.⁷: **G06F 17/50**

(21) Application number: **00939017.0**

(86) International application number:
**PCT/IE2000/000083**

(22) Date of filing: **28.06.2000**

(87) International publication number:
**WO 2001/001298 (04.01.2001 Gazette 2001/01)**

(54) **CIRCUIT LOGIC EVENT SIMULATION**

EREIGNIS-SIMULATION EINER SCHALTKREISLOGIK

SIMULATION D'EVENEMENT D'UN LOGIQUE DES CIRCUITS

(84) Designated Contracting States:
**AT BE CH CY DE DK ES FI FR GB GR IE IT LI LU MC NL PT SE**

(30) Priority: **28.06.1999 IE 990535**

(43) Date of publication of application:
**03.04.2002 Bulletin 2002/14**

(73) Proprietor: **UNIVERSITY COLLEGE DUBLIN**
**Dublin 4 (IE)**

(72) Inventor: **DALTON, Damian**
**Dublin 16 (IE)**

(74) Representative: **Schütte, Gearoid**
**Cruickshank & Company**
**8A Sandyford Business Centre**
**Sandyford**
**Dublin 18 (IE)**

(56) References cited:
- **DALTON D: "AN ASSOCIATIVE MEMORY APPROACH TO PARALLEL LOGIC EVENT-DRIVEN SIMULATION" PROCEEDINGS OF THE ANNUAL EUROPEAN CONFERENCE ON COMPUTER SYSTEMS AND SOFTWARE ENGINEERING (COMPEURO),US,LOS ALAMITOS, IEEE COMP. SOC. PRESS, vol. CONF. 6, 4 May 1992 (1992-05-04), pages 341-346, XP000344219 ISBN: 0-8186-2760-3**
- **DALTON D: "A special purpose hybrid SIMD processor for logic event simulation" PROCEEDINGS OF THE SEVENTH EUROMICRO WORKSHOP ON PARALLEL AND DISTRIBUTED PROCESSING. PDP'99, PROCEEDINGS OF 7TH EUROMICRO WORKSHOP ON PARALLEL AND DISTRIBUTED PROCESSING, FUNCHAL, PORTUGAL, 3-5 FEB. 1999, pages 74-83, XP002158195 1999, Los Alamitos, CA, USA, IEEE Comput. Soc, USA ISBN: 0-7695-0059-5**

**Description**

<u>Introduction</u>

The present invention is directed towards a parallel processing method of logic simulation comprising representing signals on a line over a time period as a bit sequence, evaluating the output of any logic gate including an evaluation of any inherent delay by a comparison between the bit sequences of its inputs to a predetermined series of bit patterns and in which those logic gates whose outputs have changed over the time period are identified during the evaluation of the gate outputs as real gate changes and only those real gate changes are propagated to fan out gates and in which the control of the method is carried out in an associative memory mechanism which stores in word form a history of gate input signals by compiling a hit list register of logic gate state changes and using a multiple response resolver forming part of the associative memory mechanism which generates an address for each hit, and then scans and transfers the results on the hit list to an output register for subsequent use. The output register may contain the final result of the simulation or may be a list of outputs to be used for subsequent fan out to other gates. Further, the invention is directed towards providing a parallel processor for logic event simulation (APPLES).

Logic simulation plays an important role in the design and validation of VLSI circuits. As circuits increase in size and complexity, there is an ever demanding requirement to accelerate the processing speed of this design tool. Parallel processing has been perceived in industry as the best method to achieve this goal and numerous parallel processing systems have been developed. Unfortunately, large speedup figures have been eluded these approaches. Higher speedup figures have been achieved, but only by compromising the accuracy of the gate delay model employed in these systems. A large communication overhead due to basic passing of values between processors, elaborate measures to avoid or recover from deadlock and load balancing techniques, is the principal barrier.

The ever-expanding size of VLSI (Very Large Scale Integration) circuits has further emphasised the need for a fast and accurate means of simulating digital circuits. A compromise between model accuracy and computational feasibility is found in logic simulation. In this simulation paradigm, signal values are discrete and may acquire in the simplest case logic values 0 and 1. More complex transient state signal values are modelled using up to 9-state logic. Logic gates can be modelled as ideal components with zero switching time or more realistically as electronic components with finite delay and switching characteristics such as inertial, pure or ambiguous delays.

Due to the enormity of the computational effort for large circuits, the application of parallel processing to this problem has been explored. Unfortunately, large speedup performance for most systems and approaches have been elusive.

Sequential (uni-processor) logic simulation can be divided into two broad categories Compiled code and Event-driven simulation (Breur et al: Diagnosis and Reliable Design of Digital Systems. Computer-Science Press, New York (1976)). These techniques can be employed in a parallel environment by partitioning the circuit amongst processors. In compiled code simulation, all gates are evaluated at all time steps, even if they are not active. The circuit has to be levellised and only unit or zero delay models can be employed. Sequential circuits also pose difficulties for this type of simulation. A compiled code mechanism has been applied to several generations of specialised parallel hardware accelerators designed by IBM, the Logic Simulation Machine LSM (Howard et al: Introduction to the IBM Los Gatos Simulation Machine. Proc IEEE Int. Conf. Computer Design: VLSI in Computers. (Oct 1983) 580-583), the Yorktown Simulation Engine (Pfister: The Yorktown Simulation Engine. Introduction 19th ACM/IEEE Design Automation Conf, (June 1982), 51-54) and the Engineering Verification Engine EVE (Dunn: IBM's Engineering Design System Support for VLSI Design and Verification. IEEE Design and Test Computers, (February 1984) 30-40 and performance figures as high as 2.2 billion gate evaluations/sec reported. Agrawal et al: Logic Simulation and Parallel Processing Intl Conf on Computer Aided Design (1990), have analysed the activity of several circuits and their results have indicated that at any time instant circuit activity (i.e. gates whose outputs are in transition) is typically in the range 1% to 0.1%. Therefore, the effective number of gate evaluations of these engines is likely to be smaller by a factor of a hundred or more. Speedup values ranging from 6 to 13 for various compiled coded benchmark circuits have been observed on the shared memory MIMD Encore Multimax multiprocessor by Soule and Blank: Parallel Logic Simulation on General purpose machines. Proc Design Automation Conf, (June 1988), 166-171. A SIMD (array) version was investigated by Kravitz (Mueller-Thuns et al: Benchmarking Parallel Processing Platforms: An Application Perspective. IEEE Trans on Parallel and Distributed systems, 4 No. 8 (Aug 1993) with similar results.

The intrinsic unit delay model of compiled code simulators is overly simplistic for many applications.

Some delay model limitations of compiled code simulation have been eliminated in parallel event-driven techniques. These parallel algorithms are largely composed of two phases; a gate evaluation phase and an event-scheduling phase. The gate evaluation phase identifies gates that are changing and the scheduling phase puts the gates affected by these changes (the fan-out gates) into a time-ordered linked schedule list, determined by the current time and the delays of the active gates. Soule and Blank: Parallel Logic Simulation on General purpose machines. Proc Design Automation Conf, (June 1988), 166-171and Mueller-Thuns et al: Benchmarking Parallel Processing Platforms:

An Application Perspective. IEEE Trans on Parallel and Distributed systems, 4 No 8 (Aug 1993) have investigated both Shared and Distributed memory Synchronous event MIMD architectures. Again, overall performance has been disappointing the results of several benchmarks executed on an 8-processor Encore Multimax and an 8-processor iPSC-Hypercube only gave speedup values ranging from 3 to 5.

Asynchronous event simulation permits limited processor autonomy. Causality constraints require occasional synchronisation between processors and rolling back of events. Deadlock between processors must be resolved. Chandy, Misra: Asynchronous Distributed Simulation via Sequence of parallel Computations. Comm ACM 24(ii) (April 1981), 198-206 and Bryant: Simulation of Packet Communications Architecture Computer Systems. Tech report MIT-LCS-TR-188. MIT Cambridge (1977) have developed deadlock avoidance algorithms, while Briner: Parallel Mixed Level Simulation of Digital Circuits Virtual Time. Ph.D. thesis. Dept of EI.Eng, Duke University, (1990) and Jefferson: Virtual time. ACM Trans Programming languages systems, (July 1985) 404-425 have explored algorithms based on deadlock recovery. The best speedup performance figures for Shared and Distributed memory asynchronous MIMD systems were 8.5 for a 14-processor system and 20 for a 32-processor BBN system.

An early version of a parallel processing method of logic simulation was described in the applicants own research paper entitled "An associative memory approach to parallel logic event driven simulation" published in the Proceedings of the Annual European Conference on Computer Systems and Software Engineering (Compeuro), US, Los Alamitos, IEEE Comp. Soc. Press, Vol Conf 6. 4 May 1992 Pages 341-346. This paper described a method of logic simulation in which the gate evaluations may be carried out in associative memory rather than in the processor. The method described obviates the need for event-scheduling mechanisms and enables the modelling of various gate-types and delay models.

An early version of a processor to carry out the method of logic simulation with associative memory is described in the applicants own paper entitled "A special purpose Hybrid SIMD processor for logic event simulation" published in the Proceedings of the Seventh Euromicro Workshop on Parallel and Distributed Processing, PDP '99, Funchal Portugal 3-5 Feb 1999, Pages 74-83. This paper introduces an architecture specifically designed for logic simulation that is not limited to a unit delay model and that can simulate complex delays such as inertial delays. Again parallel execution of logic gate evaluations is carried out in memory as opposed to in the processor.

Optimising strategies such as load balancing, circuit partitioning and distributed queues are necessary to realise the best speedup figures. Unfortunately, these mechanisms themselves contribute large Overhead communication costs for even modest sized parallel systems. Furthermore, the gate evaluation process despite its small granularity, incurs between 10 to 250 machine cycles per gate evaluation.

## Statements of Invention

The invention comprises a method as defined in claim 1 and a processor as defined in claim 15 for an Associated Parallel Processor for Logic Event Simulation; the processor is referred to in this specification as APPLES, and is specifically designed for parallel discrete event logic simulation and for carrying out such a parallel processing method. In summary, the invention provides gates evaluations in memory and replaces interprocessor communication with a scan technique. Further, the scan mechanism is so arranged as to facilitate parallelisation and a wide variety of delay models may be used.

Essentially, there is therefore provided a parallel processing method of logical simulation as defined in claim 1.

One of the core features of the invention is the segmentation or division of at least one of the registers or hit lists into smaller registers or hit lists to reduce computational time. The other feature of considerable importance is the handling of line signal propagation by modelling signal delays. Finally the method according to the invention allows simulation to be carried out over arbitrarily chosen time periods.

The associated register is divided into separate smaller associative sub-registers, one type of logic gate being allocated to each associative sub-register, each of which associative sub-registers has corresponding sub-registers connected thereto whereby gate evaluations and tests are carried out in parallel on each associative sub-register.

Further, the invention provides a parallel processor for logic event simulation (APPLES) which essentially has an associated memory mechanism which comprises a plurality of separate associative sub-registers each for the storage in word form of a history of gate input signals for a specified type of logic gate. Further, there is a number of separate additional sub-registers associated with each associative sub-register whereby gate evaluations and tests can be carried out in parallel on each associative sub-register.

In the method according to the invention, each associative sub-register is used to form a hit list connected to a corresponding separate scan register.

Ideally, when there are a number of sub-registers and the number of the one type of logic gate exceeds a predetermined number, more than one sub-register is used.

Ideally, the scan registers are controlled by exception logic using an OR gate whereby the scan is terminated for each register on the OR gate changing state thus indicating no further matches. The predetermined number will be determined by the computational load.

The scan can be carried out in many ways but one of the best ways of carrying it out is by sequential counting through the hit list and when this is done, generally the steps are performed of:-

checking if the bit is set indicating a hit;

if a hit, determining the address effected by that hit;

storing the address;

clearing the bit in the hit list;

moving to the next position in the hit list; and

repeating the above steps until the hit list is cleared.

Obviously where fan out occurs subsequently more than one address will be effected.

In one particular embodiment of the invention, there is provided such a parallel processing method of logic simulation in which each line signal to a target logic gate is stored as a plurality of bits each representing a delay of one time period, the aggregate bits representing the delay between signal output to and reception by the target logic gate and in which the inherent delay of each logic gate is represented in the same manner. The time period is arbitrarily chosen and will often be of the order of 1 nanosecond or less. The fact that the time period can be arbitrarily chosen is of immense importance since it is possible to simulate a circuit for a plurality of different time periods. Additionally the affect of the delay inherent in the transfer of line signal between logic gates is becoming more important as the response time of the components of circuits reduce.

In this latter embodiment, each delay is stored as a delay word in an associative memory forming part of the associative memory mechanism in which:-

the length of the delay word is ascertained; and

if the delay word width exceeds the associative register word width:-

the number of integer multiples of the register word width contained within the delay word is calculated as a gate state;

the gate state is stored in a further state register;

the remainder from the calculation is stored in the associative register with those delay words whose widths did not exceed the associative register word width; and

on the count of the associative register commencing:-

the state register is consulted for the delay word entered in the state register and the remainder is ignored for this count of the associative register;

at the end of the count of the associative register, the state register is updated; and

the count continues until the remainder represents the count still required.

For carrying out the invention, an initialisation phase is carried out in which specified signal values are inputted, unspecified signal values are set to unknown, test templates are prepared defining the delay model for each logic gate, the input circuit is parsed to generate an equivalent circuit consisting of 2-input logic gates, and the 2-input logic gates are then configured.

With the present invention, multi-valued logic may be applied and in this situation, n bits are used to represent a signal value at any instance in time with n being any arbitrarily chosen logic. A particularly suitable one is an 8-valued logic in which 000 represents logic 0, 111 represents logic 1 and 001 to 110 represent arbitrarily defined other signal states.

One of the features of the invention is that the sequence of values on a logic gate is stored as a bit pattern forming a unique word in the associative memory mechanism and by doing this it is possible to store a record of all values that a logic gate has acquired for the units of delay of the longest delay in the circuit.

**Detailed Description of the Invention**

The invention will be more clearly understood from the following description of embodiments thereof given by way of example only with reference to the accompanying drawings in which:-

Fig. 1 illustrates the functions of blocks of the APPLE processor;

Fig. 2 illustrates the inertial delay mechanism in the APPLE system;

Fig. 3 is an illustration of a simulated cycle;

Fig. 4 is a test search pattern;

Fig. 5 is an illustration of the logical combination mechanism according to the invention,

Fig. 6 illustrates components active during a gate evaluation phase,

Fig. 7 is bit patterns for an ambiguous delay model and hazard detection,

Fig. 8 is an outline of an alternative arrangement of processors according to the invention;

Fig. 9 illustrates the structure of one processor in more detail; and

Fig. 10 is a view similar to Fig. 1 of the alternative construction of processor.

The essential elemental tasks for parallel logic simulation are:

1. Gate evaluation.
2. Delay model implementation.
3. Updating fan-out gates.

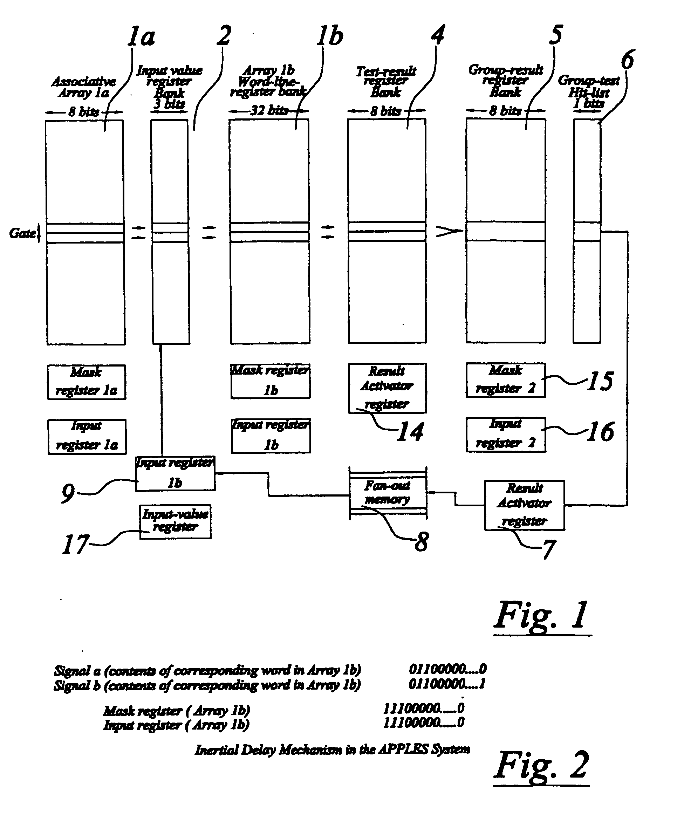

The design framework for a specific parallel logic simulation architecture originated by identifying the essential elemental simulation operations which can be performed in parallel and by minimising the tasks that support these operations and which are totally intrinsic to the parallel system.
Activities such as event scheduling and load balancing are perceived as implementation issues which need not be incorporated necessarily into a new design. An important additional critique is that the design must execute directly in hardware as many parallel tasks as possible, as fast as possible but without limiting the type of delay model.
The present invention, taking account of the above objectives, incorporates several special associative memory blocks and hardware in the APPLES architecture.
The gate evaluation/delay model implementation and Update/Fan-out process will be explained with reference to the APPLES architecture with reference to Fig. 1.
Referring to Fig. 1, the functional blocks of the APPLES processor are shown. The blocks pertinent to gate evaluation are associative array 1a 1, input-value-register bank 2, associative array 1b, test-result-register bank 4, group-result register bank 5 and the group-test hit list 6. The group test hit list in turn feeds a multiple response resolver 7 which in turn feeds a fan out memory 8 to an address register 9 connected to the input value register bank 2. The associative array 1 has an associative mask register 1a and input register 1a while the associative array 1b has a mask register 1b and an input register 1b. Similarly, the test result register bank 4 has a result active register 14 and the group result register bank 5 has a mask register 15 and an input register 16. Finally, an input value register bank 17 is provided. Apart from the associative arrays, the group-result register bank has parallel search facilities. Regardless of the number of words in these structures can be searched in parallel in constant time. Furthermore, the words in the input-value-register bank 17 and associative array 1b can be shifted right in parallel while resident in memory.
A gate can be evaluated once its input wire values are known. In conventional uni-processor and parallel systems these values are stored in memory and accessed by the processor(s) when the gate is activated. In APPLES, gate signal values are stored in associative memory words. The succession of signal values that have appeared on a particular wire over a period of time are stored in a given associative memory word in a time ordered sequence. For instance, a binary value model could store in a 32-bit word, the history of wire values that have appeared over the last 32 time intervals. Gate evaluation proceeds by searching in parallel for appropriate signal values in associative memory. Portions of the words which are irrelevant (e.g. only the 4 most recent bits are relevant for a 4-unit gate delay model) are masked out of the search by the memory's input and mask register combination. For a given gate type (e.g. And, Or) and gate delay model there are requirements on the structure of the input signals to effect an output change. Each pattern search in associative memory detects those signal values that have a certain attribute of the necessary structure (e.g. Those signals which have gone high within the last 3 time units). Those wires that have all the attributes indicate active gates. The wire values are stored in a memory block designated associative array 1 b(word-line-register bank). Only those gate types relevant to the applied search patterns are selected. This is accomplished by tagging a gate type to each word. These tags are held in associative array 1a. A specific gate type is activated by a parallel search of the designated tag in associative Array 1a.

This simple evaluation mechanism implies that the wires must be identified by the type of gate into which they flow since different gate types have different input wire sequences that activate them. Gates of a certain type are selected by a parallel search on gate type identifiers in associative array 1a.

Each signal attribute corresponds to a bit pattern search in memory. Since several attributes are normally required for an activated gate, the result of several pattern searches must be recorded. These searches can be considered as tests on words.

The result of a test is either successful or not. This can be recorded as single bit in a corresponding word in another register held in a register bank termed the test-result-register bank. Since each gate is assumed to have two inputs (inverters and multiple input gates are translated into their 2-input gate circuit equivalents) tests are combined on pairs of words in this bank. This combination mechanism is specific to a delay model and defined by the result-activator register and consists of simple AND or OR operation between bits in the word pairs.

The results of each combining each word pair, the final stage of the gate evaluation process, are stored as a single word in another associative array, the group-result register Bank 5. Active gates will have a unique bit pattern in this bank and can be identified by a parallel search for this bit pattern. Successful candidates of this search set their bit in the 1-bit column register group-test hit list.

The bits in each column position of every gate pair in the test-result register bank 4 are combined in accordance to the logic operators defined in the result-activator register. The bits in each column are combined sequentially in time in order to reduce the number of output lines in the test-result-register bank 4. Thus, there is only one output line required for each gate pair in the test-result register bank, instead of one wire for each column position.

The result of the combination of gate pairs in the test-result register bank 4 are written column by column into the group-result register bank 5. Only one column in parallel is written at a particular clock edge. This implies only one input wire to the group-result register bank 5 is required per gate pair in the test-result register bank.

This reduces the number of connections from the test-result register bank to the group-result register bank.

The scan registers are independent in so far as they can be decremented or incremented while other scan registers are disabled, however they are clocked in unison by one clock signal.

The optimum number of scan registers is given by the inverse of the probability of a hit being detected in the hit list.

It is essential that an OR operations of all bits in the Hit-list is computed on one edge of a clock period to determine when all hit bits are clear and on the converse edge of the same clock cycle any scan register that is given access to its fan-out list is permitted to clear the hit bit that it has detected. The access is controlled by a wait semaphore system to ensure only one access at a time is made to each single ported memory.

An alternative system consists of a multi-ported fan-out memory, consisting of several memory banks each of which can be simultaneously accessed. Each memory bank in the system has its own semaphore control mechanism.

An alternative strategy has a hit bit enable the inputs of its fan-out list in the Input-value register. The enable connections from the hit list to the appropriate elements in the Input-value register bank are made prior to the commencement of the simulation and are determined by the connectivity between the gates in the circuit being simulated. These connections can be made by a dynamically configured device such as an FPGA (Field Programmable Gate Array) which can physically route the hit list element to its fan-out inputs. In the process all active Fan-out elements so connected will be enabled simultaneously and updated with the same logic value in parallel.

The control core consists of a synchronised self-regulated sequence of events identified in one example, the Verilog code as e0, e1, e2 etc. An event corresponds to the completion of a major task. The self-regulation means that there is no software controlling the sequence of events, although there may be software external to the processor which will solicit information concerning the status of the processor. Furthermore, it implies that there is no microprogramming involved in the design. This eliminates the need for a microprogrammed unit and increases the speed of processing.

In the fan-out update activity controlled, for example, by e20, it is essential that the event that the Multiple response resolver 7 has no more hits to be detected, terminates this activity. There is a choice that this activity be terminated by the event that all the hit-list has been scanned. However, detection that no more hits exist can terminate prematurely this fan-out update procedure and leads to a faster execution time of this procedure.

Some logic entities may have delays which exceed the time frame representable in the word of associative array 1b. Larger delays can be modelled by associating a state with a gate type. In this case a gate and its state are defined in associative array 1a. Tests are performed on associative array 1b and when a gate with a given state passes some input value critique in addition to the fan-out components of the gate possibly being affected, the Gate state is amended in Associative array 1a. This new state may also cause a new output value to be ascribed to the fan-out list of the gate. The tests that are applied are determined by the gate type and state. In this mechanism the fan-out list of a gate includes the normal fan-out inputs and the address in associative array 1a of the gate itself.

In order to determine whether the state or the state and the fan-out gates are to be updated the state (a binary value) can serve as an offset into the gate's fan-out update data files. The state is added to the start location of each of a gates data files and this enables the gates normal fan-out list to be bypassed or not.

The interconnect between logic entities being simulated can be modelled using a large delay model described below. Furthermore, single wires can be modelled by one word instead of two in associative array 1a, associative array 1b and the test-result register bank 4. Branch points are modelled as separate wires permitting different branch points to have different delay characteristics.

An efficient implementation uses single word versions of associative array 1a, associative array 1b and the test-result register bank.

The APPLES gate evaluation mechanism selects gates of a certain type, applies a sequence of bit patterns searches (tests) to them and ascertains the active gates by recording the result of each pattern search and determining those that have fulfilled all the necessary tests. This mechanism executes gate evaluation in constant time-the parallel search is independent of the number of words. This is an effective linear speedup for the evaluation activity. It also facilitates different delay models since a delay model can be defined by a set of search patterns. Further discussion of this is given below.

Active gates set their bits in the column hit list. A multiple response resolver scans through this list. The multiple resolver can be a single counter which inspects the entire list from top to bottom which stops when it encounters a set bit and then uses its current value as a vector for the fan-out list of the identified active gate. This list has the addresses of the fan-out gate inputs in an input-value register bank. The new logic value of the active gates are written into the appropriate word of this bank.

It then clears the bit before decrementing through the remainder of the list and repeating this process. All hit bits are Ored together so that when all bits are clear. This can be detected immediately and no further scanning need be done.

Several scan registers can be used in the multiple response resolver to scan the column hit list in parallel. Each operates autonomously except when two or more registers simultaneously detect a hit; a clash has occurred. Then each scan register must wait until it is arbitrarily allowed to access and update its fan-out list. Each register scans an equal size portion. The frequency of clashes depends on the probability of a hit for each scan register, typically this probability is between 0.01 and 0.001 for digital circuits. The timing mechanism in APPLES enables only active gates to be identified and the multiple scan register structure provides a pipeline of gates to be updated for the current time interval without an explicit scheduling mechanism. The scheduler has been substituted by this more efficient parallel scan procedure.

When all gate types have been evaluated for the current time interval all signals are updated by shifting in parallel the words of the Input-value register into the corresponding words of the word-line register bank. For 8 valued logic (i.e. 3 bits for each word in the Input-value register) this phase requires 3 machine cycles. The input-value register bank can be implemented as a multi-ported memory system which allows several input values to be updated simultaneously provided that the values are located in different memory banks. Other logic values can be used.

The APPLES bit shift mechanism has made the role of a scheduler redundant. Furthermore, it enables the gate evaluation process to be executed in memory, thereby avoiding the traditional Von Neumann bottleneck. Each word pair in array 1b is effectively a processor. Major issues which cause a large overhead in other parallel logic simulation are "deadlock" and scheduling issues.

Deadlock occurs in the Chandy-Misra algorithm due to two rules required for temporal correctness, an input waiting rule and an output waiting rule. Rule one is observed by the update mechanism of APPLES. For any time interval $T_i$ to $T_{i+1}$, all words in array 1b reflect the state of wires at time $T_i$ and at the end of the evaluation and update process all wires have be updated to time $T_{i+1}$. All wires have been incremented by the smallest timestamp, one discrete time unit. Thus at the start of every time interval all gates can be evaluated with confidence that the input values are correct. The Output rule is imposed to ensure that a signal values arrive for processing in non-decreasing timestamp order. This is guaranteed in APPLES, since all signal values maintain there temporal order in each word through the shift operation. Unlike the Chandy-Misra algorithm deadlock is impossible as every gate can be evaluated at each time interval.

There is no scheduler in the APPLES system. Complex modelling such as Inertial delays have confronted schedulers with costly (timewise) unscheduling problems. Gates which have been scheduled to become active need to be de-scheduled when input signals are found to be less than some predefined minimum duration. This with the normal scheduling tasks contributes to an onerous overhead.

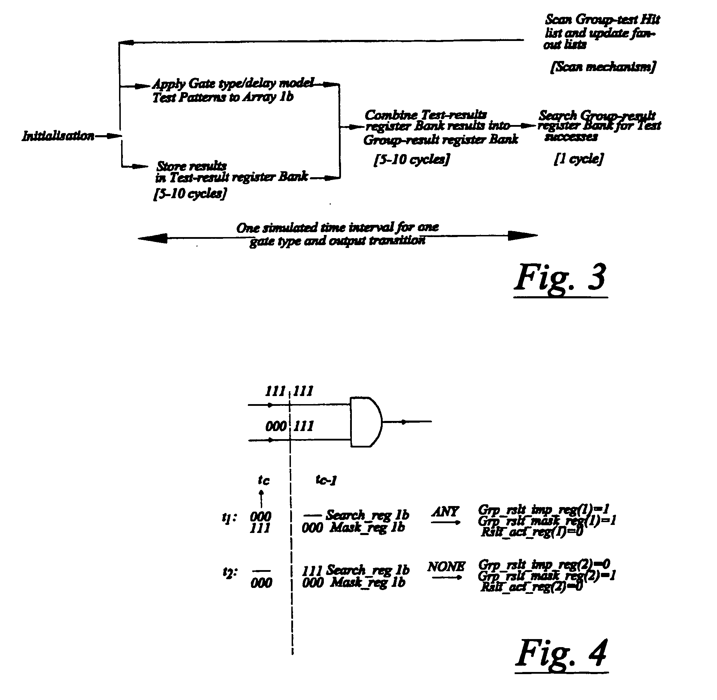

Fig. 2 displays the equivalent mechanism in APPLES. An AND gate has two inputs a and b, assume that unless signals are at least of three units duration no effect occurs at the output, the simulation involves only binary values 0 and 1 and each bit in Array 1b represents one time unit. Signal b is constant at value 1, while signal a is at logic 1 for two time units, less than the minimum time. This will be detected by the parallel search generated by the input and mask register combination and the gate will not become active.

The circuit is now ready to be simulated by APPLES and is parsed to generate the gate type and delay model and topology information required to initialise associative arrays 1a, 1b and the fan-out vector tables. There is no limit on the number of fan-out gates.

The APPLES processor assumes that the circuit to be simulated has been translated into an equivalent circuit composed solely of 2-input logic gates. Thus, every gate has two wires leading into it (an inverter has two wires from one source). These wires are organised as adjacent words in associative array 1b 1 called a word set. Associative array 1a 1 contains identifiers from every wire indicated the type of gate and input into which the wire is connected. The identifiers are in an associative memory that when a particular gate evaluation test is executed, putting the relevant bit patterns into Input-reg1a and mask-reg1a specifies the gate type. All wires connected to such gates will be identified by a parallel search on associative array1a and these will be used to activate the appropriate words in associative array1b (word-line register bank). Thus, gate evaluation tests will only be active on the relevant word sets.

The input-value register bank 17 contains the current input value for each wire. The three leftmost bits of every word in associative array 1b are shifted from this bank in parallel when all signal values are being updated by one time unit. During the update phase of the simulation, fan-out wires of active gates are identified and the corresponding words in the Input-value register bank amended.

Simulation progresses in discrete time units. For any time interval, each gate type is evaluated by applying tests on associative array 1b and combining and recording results in the neighbouring register banks. Regardless of the number of gates to be evaluated this process occupies between 10 machine cycles for the simplest, to 20 machine cycles for the more complex gate delay models, see Fig. 3. Once the fan-out gate inputs have been amended, all wires are time incremented through a parallel shift operation of 3 machine cycle duration. In general, for $2^N$ valued logic N shift operations are required to update all signal values.

Fig. 3 illustrates a simulation cycle. In the simulation cycle, the task particularly affected by the circuit size is that of scanning the hit list. As a circuit grows in size the list and sequential scan time expand proportionately. Analogous to the conventional communication overhead problem, the APPLES architecture incorporates a scan mechanism which can effectively increase the scan rate as the hit list expands. Thus, there is provided a multiple scan register structure. As will be described, one of the features of the present invention is the parallelisation of the application of test vectors in the gate evaluation phase as will be described hereinafter. Similarly, Fig. 4 is a search test pattern for an AND gate.

The series of signal values that appear on a wire over a period of discrete time units can be represented as a sequence of numbers. For example, in a binary system if a wire has a series of logic values, 1,1,0 applied to it at times $t_0$, $t_1$ and $t_2$, respectively, where $t_0 < t_1 < t_2$. The history of signal values on this wire can be denoted as a bit sequence 011; the further left the bit position, the more recent the value appeared on the wire.

Different delay models involve signal values over various time intervals. In any model, signal values stored in a word which are irrelevant are masked out of the search pattern.

The process of updating the signal values of a particular wire is achieved by shifting right by one time unit all values and positioning the current value into the leftmost position. Associative array 1b can shift right all its words in unison. The new current values are shifted into associative array 1b from the Input-value register bank.

Referring to Fig. 4, there is illustrated the parallel search patterns for an AND gate transition to logic "0".

With wire signal values represented as bit sequences in associative memory words, the task of gate evaluations can be executed as a sequence of parallel pattern searches. Figure 4 depicts the situation where 8-valued logic has been employed and the AND gate has been arbitrarily modelled as having a 1 unit delay.

Any gate which has any input satisfying $T_1$ and no(none) input satisfying $T_2$ will transition to 0.

Consequently, to determine if the output of this gate is going to transition from logic 1 to logic 0 it is necessary to know the signal values at the current time $t_c$ and $t_{c-1}$. The current values are contained in the leftmost three bits of the word set. Figure 4 declares the current values on the two inputs as logic 1='111' and logic 0='000' and the previous values as both logic 1.

To ascertain if this AND gate has an output transition to logic $0_i$ two simple bit pattern tests will suffice. If ANY current input value is logic 0 (Test $T_1$) and NONE of the previous input values are logic 0 (Test $T_2$), then the output will change to logic 0. These are the only conditions for this delay model, which will effect this transition. With associative memory any portion of a word can be active or passive in a search. Thus, putting '000' and '111' into the leftmost three bits of the search and mask registers of associative array 1 b can execute test $T_1$. Test $T_2$ can be executed by essentially the same test on the next leftmost three bit positions.

In general each test is applied one at a time. The result of test $T_i$ on $word_j$ is stored in the $i^{th}$ bit position of $word_j$ in the test-result register bank 4. A '1' indicates a successful test outcome. For each word set, for every test it is necessary to know if ANY or BOTH or NONE of the inputs passed the particular test. If the $j^{th}$ bits of $wordj$ and $word_{j-1}$ in the test-result register bank are Ored together and the result of this operation is '1', then at least one input in the corresponding word set passed the test $T_i$-the ANY condition test. If the result of the operation is '0' then no inputs passed test $T_j$ - the NONE condition test. Finally, if the $i^{th}$ bits are Anded together and the result is '1' then BOTH have passed test $T_i$.

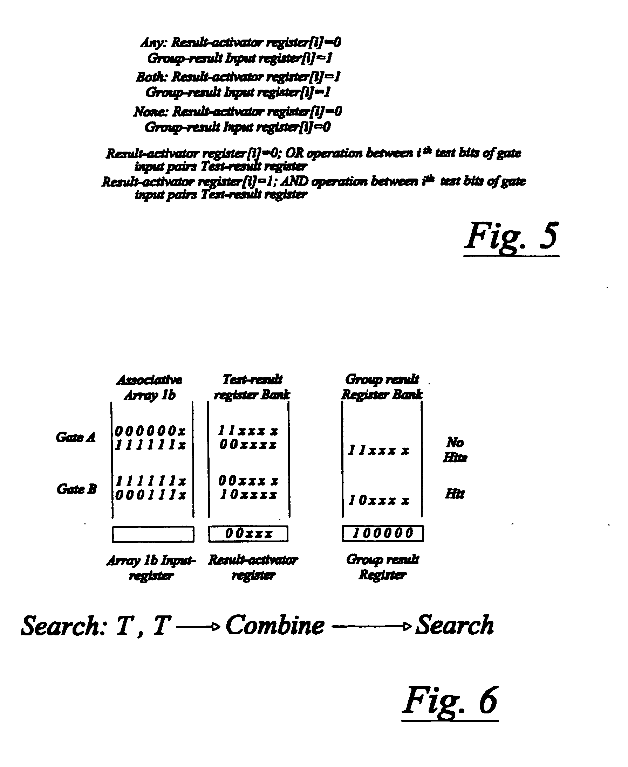

The result-activator register 14 combines results which are subsequently ascertained by the group-result register. The logical interaction is shown in Fig. 5.

The And or Or operations between the bit positions is dictated by the result activator register. A '0' in the $i^{th}$ bit position of the result activator register performs an Or action on the results of test $T_i$ for each word set in the test-result register bank and conversely a '1' an And action. Each $j^{th}$ And or Or operation is enacted in parallel through all word set Test result register pairs.

The results of the activity of the result activator register on each word set Test result register pair are saved in an associated group result register. Apart from retaining the results for a particular word set, the group result registers are composite elements in an associative array. This facilitates a parallel search for a particular result pattern and thus identifies all active gates. These gates are identified as hits (of the search in the group result register bank) in the group-test hit list.

Returning to the AND gate transition to logic '0' example, an AND gate will be identified as fulfilling the test requisites, any input passes test $T_1$ and none passing test $T_2$, if its corresponding group result register has the bit sequence '10' in the first two bit positions.

The APPLE components involved in the gate evaluation phase and their sequencing are shown in Fig. 6.

With the present invention, one of the major features of the method is the storing of each line signal to a target logic gate as a plurality of bits, each representing a delay of one time period. The aggregate bits will allow the signal output to and reception by the target logic gate to be accurately expressed. Thus, these are represented in the same manner as the inherent delay of each logic gate. What must be appreciated now is that as the speed of circuits increases, the time taken to transmit a message between two logic gates can be considerable. Thus, the lines, as well as the logic gates, have to be considered as logic entities.

Some logic entities may have delays which exceed the time frame representable in the word of associative array 1b. Larger delays can be modelled by associating a state with a gate type. In this case a gate and its state are defined in associative array 1a. Tests are performed on associative array 1b and when a gate with a given state passes some input value critique, in addition to the fan-out components of the gate possibly being affected, the Gate state is amended in Associative array 1a. This new state may also cause a new output value to be ascribed to the fan-out list of the gate. The tests that are applied are determined by the gate type and state. In this mechanism the fan-Array 1a of the gate itself.

In order to determine whether the state or the state and the fan-out gates are to be updated the state(a binary value) can serve as a selector of the gate's fan-out update data files. The state amends the access point relative to the start location of a gates data files and this enables the gates normal fan-out list to be bypassed or not.

On commencement of filling a new time frame (a word in associative array 1b), a special symbol is inserted into the left-most(most recent time) position. This symbol conveys the input value on the gate and serves as a marker. When the marker reaches the right-most position in the word, this indicates that a complete time frame has passed. This can be detected by the normal parallel test-pattern search technique on associative array 1b (See Figure 1).

The interconnect between logic entities being simulated can be modelled using the large delay model described above. Furthermore, single wires can be modelled by one word instead of two in associative array 1a, associative array 1b and the test-result register bank. Branch points are modelled as separate wires permitting different branch points to have different delay characteristics.

In effect, what is done is each delay is stored as a delay word in an associative memory forming part of the associative memory mechanism. The length of the delay word is ascertained and if the delay word width exceeds the associative register word width, then it cannot be stored in the register simply. Then, the number of integer multiples of the register word width contained within the delay word is calculated as a gate state. This gate state is stored in a further state register, in effect, the associative register or associative array 1a. The remainder from the calculation is stored in the associative register array 1b with those delay words whose width did not exceed the associative register width as well as with those words who did. Then, on the count of the associative register 16 commencing, the state register is consulted, that is to say, the associative register 1a, and the delay word entered into the register. The remainder is ignored for this count of the associative register array 1b. At the end of the count of the associative register 1b, the associative register 1a is updated by decrementing one unit. If this still does not allow the count to take place, the process is repeated. If, however, the associative register 1a is cleared, then the count continues and the remainder now represents the count required.

Complex delay models such as inertial delays require conventional sequential and parallel logic simulators to unschedule events when some timing critique is violated. This expends an extremely time consuming search through an event list. In the present invention, inertial delays only require verification that signals are at least some minimum time width; implementable as a single pattern search.

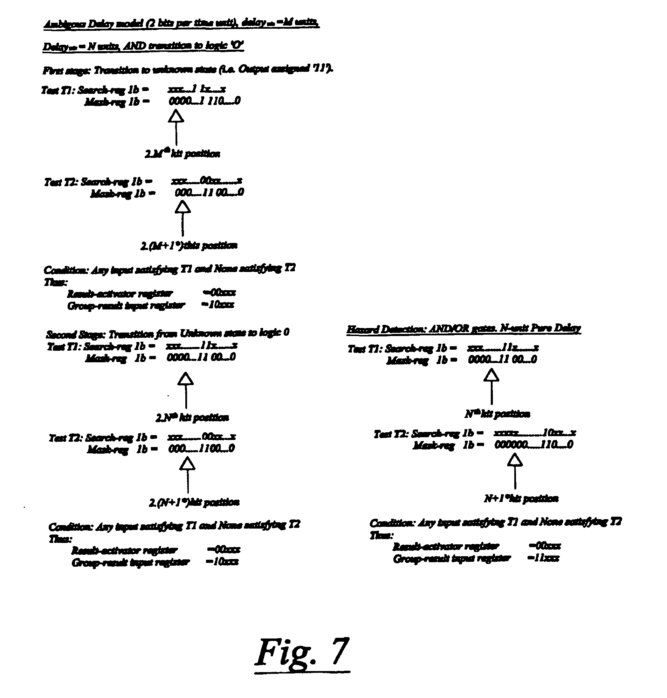

An ambiguous delay is more complicated where the statistical behaviour of a gate conveys an uncertainty in the output. A gate output acquires an unknown value between some parameters $t_{min}$ (M time units) and $t_{max}$ (N time units). Using 4-valued logic, APPLES detects an initial output change to the unknown value at time $t_{min}$, followed by the transition from unknown value to logic state '0' at time $t_{max}$, see Fig. 7. Hazard conditions, where both inputs simultaneously switch to converse values can also be detected, which is illustrated in Fig. 7.

For each gate type, the evaluation time $T_{gate-eval}$ remains constant, typically ranging from 10 to 20 machine cycles. The time to scan the hit list depends on its length and the number of registers employed in the scan. N scan registers can divide a Hit list of H locations into N equal partitions of size H/N. Assuming a location can be scanned in 1 machine cycle, the scan time, Tscan is H/N cycles. Likewise it will be assumed that 1 cycle will be sufficient to make 1 fan-out update.

For one scan register partition, the number of updates is $(Prob_{hit})$H/N. If all N partitions update without interference from other partitions this also represents the total update time for the entire system. However, while one fan-out is being updated, other registers continue to scan and hits in these partitions may have to wait and queue. The probability of this happening increases with the number of partitions and is given by $^{N}C_1(Prob_{hit})$H/N.

A clash occurs when two or more registers simultaneously detect a hit and attempt to access the single ported fan-out memory. In these circumstances, a semaphore arbitrarily authorises waiting registers accesses to memory. The number of clashes during a scan is,

$$\text{No. clashes} = (\text{Prob of 2 hits per inspection}) \times \text{H/N}$$

$$+ \text{Higher order probabilities.} \tag{1}$$

The low activity rate of circuits (typically 1%-5% of the total gate count) implies that higher order probabilities can be ignored. Assume a uniform random distribution of hits and let $Prob_{hit}$ be the probability that the register will encounter a hit on an inspection. Then (1) becomes,

$$\text{No. clashes} = {^{N}C_2}\,(Prob_{hit})^2 \times \text{H/N} \tag{2}$$

Thus, $T_N$, the average total time required to scan and update the fan-out lists of a partition for a particular gate type is,

$$T_N = T_{gate-eval} + T_{scan} + T_{update} + T_{clash}$$

$$= T_{gate-eval} + H/N + {^{N}C_1}\,(Prob_{hit})H/N + {^{N}C_2}\,(Prob_{hit})^2 \times H/N \tag{3}$$

Since all partitions are scanned in parallel, $T_N$ also corresponds to the processing time for an N scan register system. Thus, the speedup $S_p = T_1/T_N$, of such as system is,

$$T_1/f_N = \frac{T_{gate-eval} + T_{scan} + T_{update}}{T_{gate-eval} + H/N + {^{N}C_1}\,(Prob_{hit})H/N\ {^{N}C_2}(Prob_{hit})^2 \times H/N} \tag{4}$$

Eqt (4) has been validated empirically. Predicted results are within 20% of observed for sample circuits C7552 and C2670 and 30% for C1908. Nonuniformity of hit distribution appears to be the cause for this deviation.

Differentiating $T_N$ w.r.t N and ignoring 2nd order and higher powers of $Prob_{hit}$ the optimum number of scan registers $N_{optimum}$ and corresponding optimum speedup $S_{optimum}$ is given by,

$$N_{optimum} \cong (\sqrt{2})/Prob_{hit} \tag{5}$$

$$S_{optimum} \cong 1/(2.4 \times Prob_{hit}) \tag{6}$$

Thus, the optimum number of scan registers is determined inversely by the probability of a hit being encountered in the Hit list. In APPLES, the important processing metric is the rate at which gates can be evaluated and their fan-out lists updated. As the probability of a hit increases there will be a reciprocal increase in the rate at which gates are updated. Circuits under simulation which happen to exhibit higher hit rates will have a higher update rate.

When the average fan-out time is not one cycle, $Prob_{hit}$ is multiplied by Fout, where Fout is the effective average fan-out time.

A higher hit rate can also be accomplished through the introduction of extra registers. An increase in registers increases the hit rate and the number of clashes. The increase halts when the hit rate equals the fan-out update rate, this occurs at $N_{optimum}$. This situation is analogous to a saturated pipeline. Further increases in the number of registers serves to only increase the number of clashes and waiting lists of those registers attempting to update fan-out lists.

Further simulations were carried out, again with a Verilog model of APPLES simulated 4 ISCAS-85 benchmarks, C7552(4392 gates), C2670(1736 gates), C1908(1286 gates), C880(622 gates) using a unit delay model. Each was exercised with 10 random input vectors over a time period ranging from 1,000 to 10,000 machine cycles. Statistics were gathered as the number of scan registers varied from 1 to 50. The speedup relative to the number of scan registers is shown in Table 1.

Table 1.

| Speedup Performance of Benchmarks | | | | | | | | |
|---|---|---|---|---|---|---|---|---|
| **No. Scan Registers** | | | | | **No. Scan Registers** | | | |
| | 1 | 15 | 30 | 50 | 1 | 15 | 30 | 50 |
| **C7552** | 1 | 12.5 | 19.9 | 24.3 | 1 | 13.6 | 24.3 | 29.6 |
| **C2670** | 1 | 9.7 | 13.8 | 15.9 | 1 | 12.5 | 20.0 | 25.1 |
| **C1908** | 1 | 8.4 | 10.8 | 11.8 | 1 | 11.8 | 17.3 | 20.9 |
| **C880** | 1 | 7.8 | 8.3 | 9.7 | 1 | 11.1 | 12.6 | 15.9 |
| **Speedup** | | | | | **Speedup(excl Fixed size Overheads)** | | | |
| (a) | | | | | (b) | | | |

Table (1.a) demonstrates that in general the speedup increases with the number of scan registers. The fixed sized overheads of gate evaluation, shifting inputs etc, tends to penalise the performance for the smaller circuits with a large number of registers. A more balanced analysis is obtained by factoring out all fixed time overheads in the simulation results. This reflects the performance of realistic, large circuits where the fixed overheads will be negligible to the scan time. Table (1.b) details the results with this correction. As expected this correction has lesser affect on the larger bench mark circuits.

Table 2.

| Average No. of machine cycles per gate processed | | | | |
|---|---|---|---|---|
| Av. No. Cycles/Gate Processed No. Scan Registers | | | | |
| | 1 | 15 | 30 | 50 |
| **C7552** | 154.6 | 11.3 | 6.4 | 5.2 |
| **C2670** | 101.9 | 8.0 | 5.1 | 3.9 |
| **C1908** | 86.9 | 6.8 | 5.1 | 3.9 |
| **C880** | 49.9 | 4.9 | 4.2 | 3.6 |

Taking the corrected simulated performance statistics, Table (2) displays the average number of machine cycles expended to process a gate. The APPLES system detects intrinsically only active gates, no futile updates or processing is executed. The data takes into account the scan time between hits and the time to update the fan-out lists. As more registers are introduced the time between hits reduces and the gate update rate increases. Clashes happen and active gates are effectively queued in a fan-out/update pipeline. The speedup saturates when the fan-out/update rate, governed by the size of the average fan-out list, equals the rate at which they enter the pipeline.

The benchmark performance of the circuits also permits an assessment of the validity of the theory for the speedup. From the speedup measurements in Table1.(b) the corresponding value for $f_{av}$ was calculated using Eqt(7). This value representing the average fan-out update time in machine cycles, should be constant regardless of the number of scan registers. Furthermore, for the evaluated benchmarks the fan-out ranged from 0 to 3 gates and the probability of a hit, $Prob_{hit}$, was found to be $0.01 \pm 5\%$. Within one and a half clock cycles it is possible to update 2 fan-out gates, therefore depending on the circuit $f_{av}$ should be in the range 0.5 to 1.5. The calculated values $f_{av}$ for are shown in Table 3.

Table 3.

| The Average Fan-out Update Time (in machine cycles) for the Benchmarks | | | |
|---|---|---|---|
| | **No. Scan Registers** | | |
| | 15 | 30 | 50 |
| | Av | | |
| C7552 | 0.41 | 0.35 | 0.88 |
| | 0.55 | | |
| C2670 | 0.52 | 0.79 | 1.26 |
| | 0.86 | | |
| C1908 | 0.77 | 1.21 | 1.32 |
| | 1.10 | | |
| C880 | 0.16 | 1.98 | 1.54 |
| | 1.22 | | |
| | | $f_{av}$ | |

The values for $f_{av}$ are in accord with the range expected for the fan-out of these circuits. The fluctuations in value across a row for $f_{av}$, where it should be constant are possibly due to the relatively small number of samples and size of circuits, where a small perturbation in the distribution of hits in the hit-list can affect significantly the speedup figures. In the case of C880, a 10% drop in speedup can effectively lead to a ten-fold increase in $f_{av}$.

For comparison purposes Table 4 uses data from Banerjee: Parallel Algorithms for VLSI Computer-Aided Design. Prentice-Hall, 1994 which illustrates the speedup performance on various parallel architectures for circuits of similar size to those used in this paper. This indicates that APPLES consistently offers higher speedup.

For comparison purposes Table 4 uses data from Banerjee: Parallel Algorithms for VLSI Computer-Aided Design. Prentice-Hall, 1994 which illustrates the speedup performance on various parallel architectures for circuits of similar size to those used in this paper. This indicates that APPLES consistently offers higher speedup.

TABLE 4 -

| A speedup comparison of other parallel architectures | | | | |
|---|---|---|---|---|
| Architecture | Synchronous | | Asynchronous | |
| | Shared Memory | Distributed Memory | Shared Memory | Distributed Memory |
| **Circuit** | | | | |
| Multiplier (4990 gates) | 5.0/8 | / | 5.0/8,5.8,14 | / |
| H-FRISC (5060 gates) | 3.7/8 | / | 7.0/8, 8.2/14 | / |
| S15850 (9772 gates) | / | 3.2/8 | / | / |
| S13207 (7951 gates) | / | 3.2/8 | / | / |
| Adder (400 gates) | / | / | 4.5/16, 6.5/32 | / |
| QRS (1000 gates) | / | / | 5.0/16, 7.0/32 | / |
| **Speedup Performance for Various Parallel Systems** | | | | |
| **Notation a/b, where a = Speedup value, b = No. Processors.** | | | | |
| **Double entries denote two different systems of the same architecture** | | | | |

The following from pages 28 to 54 is one example of an implementation of the present invention in software written in Verilog.

# Verilog Description of APPLES

## Associative Array1a

**Description: Each word of this array holds a bit sequence identifying the gate type input connection of a wire, in the corresponding position in Associative Array1b. The input/mask register combination defines a gate type that will be activated for searching in Associative Array1a. Words that successfully match are indicated in a 1-bit column register. The array also has write capabilties.**

```
module Ary_1a(Input_reg1a,Mask_reg1a,Adr_reg1a,Clock,
              Search_enbl1a,Write_enbl1a,Activ_lst1a);

// Input_reg1a, Mask_reg1a, Adr_reg1a are the Input,Mask and Address registers
   of Associative Array1a.
   When Search_enbl1a is set, the negative edge of Clock initiates a parallel
   search.
   Activ_lst1a is a column register that indicates those words in Associative
   Array1a which compared successfully with the search pattern.                //

parameter Ary_1a_wdth=7;
parameter Ary1a_size=16383;
integer Ary_index;

input Clock,Search_enbl1a,Write_enbl1a;

input[Ary_1a_wdth:0] Input_reg1a, Mask_reg1a, Adr_reg1a;

output [Ary1a_size:0] Activ_lst1a;
reg [Ary1a_size:0] Activ_lst1a;

reg [Ary_1a_wdth:0] Ary1a_ass_mem[0:Ary1a_size], Temp_reg;

initial
  begin
    $readmemb("Ary1a.dat",Ary1a_ass_mem);

// Ary1a.dat is the data file defining the gate and model types in the circuit.//

    for (Ary_index=0; Ary_index<=Ary1a_size; Ary_index=Ary_index+1)
      begin
       Activ_lst1a[Ary_index]=0;
      end
  end

always @(negedge Clock)
begin
  if (Search_enbl1a)
   begin
   for (Ary_index=0; Ary_index<=Ary1a_size; Ary_index=Ary_index+1)
    begin
    Temp_reg=Ary1a_ass_mem[Ary_index];
    if (((~Mask_reg1a | (Input_reg1a & Temp_reg) |
                        (~Input_reg1a & ~Temp_reg))==8'hff)
        Activ_lst1a[Ary_index]=1;
     else
```

```
                Activ_1st1a[Ary_index]=0;
          end
         end
      if (Write_enbl1a) Ary1a_ass_mem[Adr_reg1a]= Input_reg1a;
    end

    endmodule
```

## Associative Array1b

**Description: Every word in this array represents the temporal spread of signal values on a specific wire. The most recent values being leftmost in each word. All words can be simultaneously shifted right, effecting a one unit time increment on all wires. The signal values are updated from a 1-bit column register. The array has parallel search and read and write capabilities.**

```
module  Ary_1b ( Search_reg1b, Mask_reg1b, Adr_reg1b, Datain_reg1b,
          Dataout_reg1b,Hit_buffr_reg1b, Shft_enbl, Search_enbl1b,
          Write_enbl, Read_enbl,Clock,Input_bit,
          Word_line_enbl);

// Search_reg1b, Mask_reg1b, Adr_reg1b, Datain_reg1b,Dataout_reg1b are the
Search,Mask, Address,Data-in and data-out registers of Associative Array1b.
When Search_enbl1b is set, the negative edge of Clock initiates a parallel
search. Likewise, a read or write operation is executed on the negative edge of
the clock if Write_enbl or Read_enbl is asserted.
A parallel search is initiated on a negative edge of the Clock if Search_enbl1b is
set. This search is only active on those words that are primed for searching by
the Word_line_enbl column regsiter. The bits in this register are set/cleared by
Activ_1st1a of Associative Array1a. This effectively selects gates of a certain
gate type and delay model. Words that match are identified by bit being set in the
corresponding position in Hit_buffr_reg1b.
Words are shifted right in parallel with the leftmost bit being taken from
Input_bit.//


parameter Ary1b_mem_size=16383;
parameter Wlr_wrdsize =31;
parameter Shft_dly=2;
parameter Adr_reg_bits=13;

input[Wlr_wrdsize:0] Search_reg1b, Mask_reg1b, Datain_reg1b;
input[Ary1b_mem_size:0] Input_bit,Word_line_enbl;

input           Clock;

input           Shft_enbl,Search_enbl1b,Write_enbl,Read_enbl;



reg [Wlr_wrdsize:0]  Temp_reg1;
reg [Wlr_wrdsize:0]  Wlr_Ass_mem[0:Ary1b_mem_size];

input [Adr_reg_bits:0] Adr_reg1b;


output [Ary1b_mem_size:0] Hit_buffr_reg1b;
reg    [Ary1b_mem_size:0] Hit_buffr_reg1b;

output [Wlr_wrdsize:0] Dataout_reg1b;
reg    [Wlr_wrdsize:0] Dataout_reg1b;
```

```
integer Mem_indx;

initial $readmemb("Array1b.dat",Wlr_Ass_mem);
//Array1b.dat is the file which initialises all the words in Arraylb to the
Unknown value.//


always @(negedge Clock)
   begin

      if (Shft_enbl)
      begin
         for (Mem_indx=0; Mem_indx<=Ary1b _mem_size ; Mem_indx= Mem_indx + 1)
            begin

               Temp_reg1 = Wlr_Ass_mem[Mem_indx];

               Temp_reg1= Temp_reg1 >> 1;

               Temp_reg1[Wlr_wrdsize] = Input_bit[Mem_indx];

               Wlr_Ass_mem[Mem_indx] = Temp_reg1;

            end
      end

      else
      if (Search_enbl1b)
      begin
      for (Mem_indx=0; Mem_indx<=Ary1b_mem_size ; Mem_indx = Mem_indx + 1)
       begin

       if (Word_line_enbl[Mem_indx])
         begin
            Temp_reg1 = Wlr_Ass_mem [Mem_indx];

            if ((~Mask_reg1b | (Search_reg1b & Temp_reg1) |
                  (~Search_reg1b & ~Temp_reg1))==32'hffffffff)
            begin
            Hit_buffr_reg1b[Mem_indx] = 1;
            end
            else
            begin
            Hit_buffr_reg1b[Mem_indx] = 0;
            end
          end
        else
         Hit_buffr_reg1b[Mem_indx] = 0;
         end

      end

      else
      if (Write_enbl)
            Wlr_Ass_mem[Adr_reg1b] = Datain_reg1b;

      else
      if (Read_enbl)
            Dataout_reg1b = Wlr_Ass_mem[Adr_reg1b];


   end
endmodule
```

## Test-result register Bank

Description: When an $i^{th}$ search is executed on Associative Array1b, if word$_j$ in Array1b matches the search pattern, then bit$_i$ in word$_j$ of the Test-result register bank will be set, otherwise it is cleared. The Result-activator register specifies the logical combination between pairs of words( a gate's set of inputs). The result of this combination of word pairs is a column register (half the length of the number of word pairs).

```
module Tst_rslt_reg_bank(Inp_buffr_reg,Trr_wrt_enbl,Comb_enbl,Clock,
                         Out_buffr_reg,Rslt_act_reg,Write_pos,Rset);

// Inp_buffr_reg is a column of bits describing the outcome of a search on each
word in Array1b. This bit column is written into a column of the Test-result
register bank on the negative edge of Clock when Trr_wrt_enbl is asserted. The
position of this coulmn is defined by Write_pos.
Word pairs are combined according to the bit sequence in Rslt_act_reg. A '0' in
bit_i of Rslt_act_reg ORs the i^th bits in each word pair and produces the result for
each pair in Out_buffr_reg. This combination is executed on the negative edge of
Clock when Comb_enbl is asserted. Rset resets all the bits in the Test-result
register bank.//

parameter  Trr_word_size=7;
parameter  Trr_mem_size=16383;
parameter  Trr_out_size=8191;
parameter  Trr_wdth_spec=2;

reg[Trr_word_size:0]  Trr_array[0:Trr_mem_size];
reg[Trr_word_size:0]  Temp_reg1, Temp_reg2;
reg  Rslt_action;


input [Trr_mem_size:0] Inp_buffr_reg;
input [Trr_word_size:0] Rslt_act_reg;
input [Trr_wdth_spec:0] Write_pos;
input Clock;
input Trr_wrt_enbl;
input Comb_enbl;
input Rset;


output [Trr_out_size:0] Out_buffr_reg;
reg[Trr_out_size:0]     Out_buffr_reg;

integer Bank_index,i;



always @(negedge Clock)
 begin

    if (Trr_wrt_enbl)
      begin
      for (Bank_index=0; Bank_index<=Trr_mem_size; Bank_index=Bank_index+1)
         begin
         Temp_reg1=Trr_array[Bank_index];
         Temp_reg1[Write_pos]=Inp_buffr_reg[Bank_index];
         Trr_array[Bank_index]=Temp_reg1;
         end
```

```
          end

      else



      if (Comb_enbl)
       begin
       Rslt_action=Rslt_act_reg[Write_pos];
       for (i=0; i<=Trr_word_size; i=i+1)
         begin
          for(Bank_index=0;Bank_index<Trr_mem_size;Bank_index=Bank_index+2)
          begin
          Temp_reg1=Trr_array[Bank_index];
          Temp_reg2=Trr_array[Bank_index+1];
          if (Rslt_action==0)

            Out_buffr_reg[Bank_index/2]=(Temp_reg1[Write_pos] |
                                        Temp_reg2[Write_pos]);
          else

            Out_buffr_reg[Bank_index/2]=Temp_reg1[Write_pos] &
                                        Temp_reg2[Write_pos];

          end
         end

      end


      else

      if (Rset)
       begin
           for(Bank_index=0;Bank_index<=Trr_mem_size;Bank_index=Bank_index+1)
            Trr_array[Bank_index]=8'h00;
       end


   end

 endmodule
```

## Group-result register Bank

Description: The result of the combination of word pairs in the Test-result register is written as a column of bits into the Group-result register bank. When all combination results have been generated a parallel search is executed on the Group-result register to ascertain all word pairs in Array1b that passed all the test pattern searches.

```
module Grp_rslt_reg_bank(Grr_inp_reg,Grr_mask_reg,Grr_srch_reg,
                         Clock,Srch_enbl,Wrt_enbl,Write_pos,
                         Grr_hit_list);

// Grr_inp_reg is shifted as a bit column into a column of the Group-result
register bank defined by Write_pos. This column write operation is activated on
the negative edge of Clock when Wrt_enbl is asserted.
Grr_mask_reg and Grr_srch_reg compose a search pattern enacted on the negative
edge of Clock when Srch_enbl is set. Pattern matches are indicated in
Grr_hit_list. The Grr_hit_list is also known as the Group-test Hit list.//

parameter Grr_mem_size=8191;
parameter Grr_word_size=7;
parameter Grr_wdth_spec=2;

input [Grr_mem_size:0] Grr_inp_reg;

input [Grr_word_size:0] Grr_mask_reg,Grr_srch_reg;

input [Grr_wdth_spec:0] Write_pos;

input Clock,Srch_enbl,Wrt_enbl;

output [Grr_mem_size:0] Grr_hit_list;
reg    [Grr_mem_size:0] Grr_hit_list;

reg [Grr_word_size:0] Grr_array[0:Grr_mem_size];
reg [Grr_word_size:0] Temp_reg;

integer Bank_index;

always @(negedge Clock)

        if (Wrt_enbl)
         begin
         for (Bank_index=0; Bank_index<=Grr_mem_size;
                                    Bank_index=Bank_index + 1)
         begin
           Temp_reg= Grr_array[Bank_index];
           Temp_reg[Write_pos]= Grr_inp_reg[Bank_index];
           Grr_array[Bank_index]=Temp_reg;
         end
         end
        else if (Srch_enbl)

         for (Bank_index=0;Bank_index<=Grr_mem_size;
                                    Bank_index=Bank_index+1)
         begin
         Temp_reg = Grr_array[Bank_index];
         if ((~Grr_mask_reg | (Grr_srch_reg & Temp_reg) |
```

```
                              (-Grr_srch_reg & -Temp_reg))==8'hff)
                    Grr_hit_list[Bank_index] = 1;
                 else
                    Grr_hit_list[Bank_index] = 0;
              end

        endmodule
```

## Multiple-response resolver (Version 1.0 Single Scan mode)

Description: The Multiple-response resolver scans the Group-test Hit list ( a 1-bit column register). The resolver commences a scan by initialising its counter with the top address of the Hit list. This counter serves as an address register which facilitates reading of every Hit list bit. If the inspected bit is set, the fan-out list of the associated gate is accessed and updated appropriately. The bit is then reset. After reset or if the bit was already zero, the counter is decremented to point to the next address in the Hit list. The inspection process is repeated. The scanning terminates either when all bits have been inspected or all bits are zero.

```
module Multiple_res_res(Grr_hit_list,Clock,
                        Reset_ctr,End_scan_flag,Decrmt_enbl,
                        Fan_out_src_reg,Fan_out_size_reg,Rset_hit_fnd_flg,
                        Hit_fnd_flag);

// The Multiple_response_resolver inspects a new bit of Grr_hit_list on the
negative edge of Clock while Decrmt_enbl is asserted. Reset_ctr loads the
resolver's counter with top location of Hit list. If the current inspected bit is
set, Hit_fnd_flag is asserted and the vector and the size (no. of gates) for the
fan-out list loaded into Fan_out_src_reg and Fan_out_size_reg, respectively.
Scanning halts and only recommences on the positive edge of Rset_hit_fnd_flg which
is externally controlled. Scanning terminates when all bits have been inspected or
reset to zero. This condition is indicated by End_scan_flag.//

parameter Grr_mem_size=8191;
parameter Vectr_tbl_adr_reg_bits=13;
parameter Fanout_hdr_tbl_wdth=13;
parameter Max_fan_out=7;
parameter Inp_bnk_size=16383;


input Reset_ctr,Rset_hit_fnd_flg,Clock;
input[Grr_mem_size:0] Grr_hit_list;

input Decrmt_enbl;

output End_scan_flag;
reg End_scan_flag;

output Hit_fnd_flag;
reg Hit_fnd_flag;

output Fan_out_src_reg;
reg[Vectr_tbl_adr_reg_bits:0] Fan_out_src_reg;

output Fan_out_size_reg;
reg[Max_fan_out:0] Fan_out_size_reg;

reg[Fanout_hdr_tbl_wdth:0] Fan_out_hdr_tbl[0:Inp_bnk_size];

reg[Vectr_tbl_adr_reg_bits:0] Hit_lst_ctr;

reg[Max_fan_out:0] Fan_out_size_tbl[0:Inp_bnk_size];
reg[Grr_mem_size:0] Hit_lst_buffr;

reg Hit_fnd_ORed_flg,Tst_or_bit;
```

```
integer Num_hits,Hit_dist,Sum_hit_dist,Prev_hit_lst_ctr,Avg_dist;


initial $readmemh('Fanout.dat', Fan_out_hdr_tbl);
//The file Fanout.dat contains the vectors for the start of the fan-out lists for
every gate in the circuit being simulated.//

initial $readmemh('Fansize.dat',Fan_out_size_tbl);
//The file Fansize.dat specifies the size of the fan-out list for each gate being
simulated.//

initial forever
begin
 @(Reset_ctr)
 if (Reset_ctr)
  begin
  Num_hits=0;
  Prev_hit_lst_ctr=Grr_mem_size;
  Sum_hit_dist=0;
  Hit_lst_buffr=Grr_hit_list;
  Tst_or_bit=|Grr_hit_list;
  $display('OR Check=%b',Tst_or_bit);
  Hit_lst_ctr=Grr_mem_size;
  End_scan_flag=0;
  Hit_fnd_flag=0;
  Hit_fnd_ORed_flg=1;
  $display('Initialisation seq executed');
  end
end



always @(negedge Clock)
   begin

   if ((Decrmt_enbl) && (! End_scan_flag))
     begin
     Hit_fnd_ORed_flg=|Hit_lst_buffr;
     if ((Hit_lst_ctr>0) && ( Hit_fnd_ORed_flg))
        begin
         if (Hit_lst_buffr[Hit_lst_ctr]==1)
           begin
           Num_hits=Num_hits + 1;
           Hit_dist=Prev_hit_lst_ctr - Hit_lst_ctr;
           Sum_hit_dist=Hit_dist+Sum_hit_dist;
           $display('Hit distance=%d',Hit_dist,'Time=%d',$time);
           Prev_hit_lst_ctr=Hit_lst_ctr;
           Fan_out_size_reg=Fan_out_size_tbl[Hit_lst_ctr];
           Fan_out_src_reg=Fan_out_hdr_tbl[Hit_lst_ctr];
           Hit_fnd_flag=1;
           Hit_lst_buffr[Hit_lst_ctr]=0;
           end
        end


   if ((Hit_lst_ctr>0) && (! Hit_fnd_ORed_flg))
      begin
       End_scan_flag=1;
       $display("No of hits in fan-out list=%d",Num_hits);
       Avg_dist=Sum_hit_dist/Num_hits;
       $display('Average hit distance=%d',Avg_dist);

      end


   if (Hit_lst_ctr==0)
      begin
       if (Hit_lst_buffr[Hit_lst_ctr]==1)
```

```
            `begin
            Num_hits=Num_hits + 1;
            Hit_dist=Prev_hit_lst_ctr-Hit_lst_ctr;
            $display('Hit distance=%d',Hit_dist);
            Prev_hit_lst_ctr=Hit_lst_ctr;
            Sum_hit_dist=Hit_dist+Sum_hit_dist;

            Fan_out_size_reg=Fan_out_size_tbl[Hit_lst_ctr];
            Fan_out_src_reg=Fan_out_hdr_tbl[Hit_lst_ctr];
            Hit_fnd_flag=1;
            end
         End_scan_flag=1;
         $display('No of hits in fan-out list=%d',Num_hits);
         Avg_dist=Sum_hit_dist/Num_hits;
         $display('Average hit distance=%d',Avg_dist);
       end

    Hit_lst_ctr=Hit_lst_ctr -1;
      end
   end

always @(posedge Rset_hit_fnd_flg)
   begin
   Hit_fnd_flag=0;
   end


endmodule
```

## Multiple_Response Resolver (Version 2.0 Multiple Scan Mode)

Description: The Multiple-response resolver scans the Group-test Hit list ( a 1-bit column register). The resolver in Multiple Scan Mode consists of several counter(scan) registers. Each is assigned an equal size portion of the Group-test Hit list. When the resolver is initialised all scan registers point to the top of their respective Hit list segment. The registers are synchronised by a single clock. The external functionality of the Multiple Scan Mode resolver is identical to that of the Single Scan Mode version. Internally, the Multiple Scan version uses a Wait semaphore to queue multiple accesses to the the fan-out lists. Registers which clash are queued arbitrarily and only recommence scanning after gaining permission to update their fan-out lists. Scanning terminates when all bits have been inspected or all bits are zero.

```
module Multiple_res_res(Grr_hit_list,Clk,
                        Reset_ctr,End_scan_flag,Decrmt_enbl,
                        Fan_out_src_reg,Fan_out_size_reg,Rset_hit_fnd_flg,
                        Hit_fnd_flag);

//  The  Multiple_response_resolver  inspects  in  parallel  several  bits  of
Grr_hit_list  on  the  negative  edge  of  Clock  while  Decrmt_enbl  is  asserted.
Reset_ctr  loads  the  resolver's  scan  registers  with  the  top  location  of  each
respective  segment  of  the  Hit  list.  If  any  of  the  current  inspected  bits  are  set,
Hit_fnd_flag  is  asserted.  The  vector  and  the  size  (no.  of  gates)  for  the  fan-out
list  of  the  segment  which  has  been  granted  permission,  is  loaded  into
Fan_out_src_reg  and  Fan_out_size_reg,  respectively.  Scanning  halts  for  all
registers  awaiting  permission.  Permission  is  arbitrarily  granted  to  a  segment  on
the  positive  edge  of  Rset_hit_fnd_flg  which  is  externally  controlled.  For
registers  that  have  not  found  a  hit,  a  new  bit  is  inspected  on  the  negative  edge
of  Clock.  Scanning  terminates  when  all  bits  have  been  inspected  or  reset  to  zero.
This  condition  is  indicated  by  End_scan_flag.//


parameter Grr_mem_size=8191;
parameter Vectr_tbl_adr_reg_bits=13;
parameter Fanout_hdr_tbl_wdth=13;
parameter Max_fan_out=7;
parameter Inp_bnk_size=16383;

input Reset_ctr,Rset_hit_fnd_flg,Clk;
input[Grr_mem_size:0] Grr_hit_list;

input Decrmt_enbl;

output End_scan_flag;
reg End_scan_flag;

output Hit_fnd_flag;
reg Hit_fnd_flag;

output Fan_out_src_reg;
reg[Vectr_tbl_adr_reg_bits:0] Fan_out_src_reg;

output Fan_out_size_reg;
reg[Max_fan_out:0] Fan_out_size_reg;

reg[Fanout_hdr_tbl_wdth:0] Fan_out_hdr_tbl[0:Inp_bnk_size];
```

```
reg[Max_fan_out:0] Fan_out_size_tbl[0:Inp_bnk_size];
reg[Grr_mem_size:0] Hit_lst_buffr;

reg Hit_fnd_ORed_flg,Tst_or_bit,Mpl_scan_enbl;

integer Num_hits,Num_hits_ratio,Start_time,Finish_time;

reg  decrmt_enbl1,decrmt_enbl2,decrmt_enbl3,decrmt_enbl4,mem_access;
reg  decrmt_enbl5,decrmt_enbl6,decrmt_enbl7,decrmt_enbl8;
------------------------------------------------------------
reg  decrmt_enbl25,decrmt_enbl26,decrmt_enbl27,decrmt_enbl28;
reg  decrmt_enbl29,decrmt_enbl30;

//These registers enable a segment to be scanned when asserted. This program
assumes that the list is divided into 30 equalled size segments.//


integer c1,c2,c3,c4,c5,c6,c7,c8;
---------------------------------
integer c25,c26,c27,c28,c29,c30,Total;

reg[Vectr_tbl_adr_reg_bits:0]  pos1,pos2,pos3,pos4,pos5,pos6,pos7,pos8;
------------------------------------------------------------------------
reg[Vectr_tbl_adr_reg_bits:0]  pos25,pos26,pos27,pos28,pos29,pos30;

// These  are the scan registers  for each segment.//

parameter  upr_lt1= 149;
parameter  lwr_lt1= 0;
parameter  upr_lt2= 299;
parameter  lwr_lt2= 150;
parameter  upr_lt3= 449;
parameter  lwr_lt3= 300;
parameter  upr_lt4= 599;
parameter  lwr_lt4= 450;
parameter  upr_lt5= 749;
parameter  lwr_lt5= 600;
parameter  upr_lt6= 899;
parameter  lwr_lt6= 750;
---------------------------
parameter  upr_lt27= 4049;
parameter  lwr_lt27= 3900;
parameter  upr_lt28= 4199;
parameter  lwr_lt28= 4050;
parameter  upr_lt29= 4349;
parameter  lwr_lt29= 4200;
parameter  upr_lt30= 4392;
parameter  lwr_lt30= 4350;

// These parameters define the upper and lower limits of the segments of the
Group-test Hit list.//

initial
 begin
   pos1=upr_lt1;
   pos2=upr_lt2;
   pos3=upr_lt3;
   pos4=upr_lt4;
   pos5=upr_lt5;
   pos6=upr_lt6;
   --------------
   pos27=upr_lt27;
   pos28=upr_lt28;
   pos29=upr_lt29;
```

```
pos30=upr_lt30;

decrmt_enbl1=1;
decrmt_enbl2=1;
decrmt_enbl3=1;
decrmt_enbl4=1;
decrmt_enbl5=1;
decrmt_enbl6=1;
decrmt_enbl7=1;
---------------
decrmt_enbl27=1;
decrmt_enbl28=1;
decrmt_enbl29=1;
decrmt_enbl30=1;


c1=0;
c2=0;
c3=0;
c4=0;
c5=0;
c6=0;
-----
c27=0;
c28=0;
c29=0;
c30=0;
mem_access=1;
end

initial $readmemh("Fanout.dat", Fan_out_hdr_tbl);
//The file Fanout.dat contains the vectors for the start of the fan-out lists for
every gate in the circuit being simulated.//

initial $readmemh("Fansize.dat",Fan_out_size_tbl);
//The file Fansize.dat specifies the size of the fan-out list for each gate being
simulated.//

initial forever
begin
 @(Reset_ctr)
 if (Reset_ctr)
  begin
  Num_hits=0;
  Hit_lst_buffr=Grr_hit_list;
  Tst_or_bit=|Grr_hit_list;
  $display("OR Check=%b",Tst_or_bit);
  End_scan_flag=0;
  Hit_fnd_flag=0;
  Hit_fnd_ORed_flg=1;
   pos1=upr_lt1;
   pos2=upr_lt2;
   pos3=upr_lt3;
   pos4=upr_lt4;
   pos5=upr_lt5;
   pos6=upr_lt6;
   ---------------
   pos27=upr_lt27;
   pos28=upr_lt28;
   pos29=upr_lt29;
   pos30=upr_lt30;

   decrmt_enbl1=1;
   decrmt_enbl2=1;
   decrmt_enbl3=1;
   decrmt_enbl4=1;
   decrmt_enbl5=1;
   decrmt_enbl6=1;
```

```
-------'-------
decrmt_enbl27=1;
decrmt_enbl28=1;
decrmt_enbl29=1;
decrmt_enbl30=1;


c1=0;
c2=0;
c3=0;
c4=0;
c5=0;
c6=0;
-----
c27=0;
c28=0;
c29=0;
c30=0;

mem_access=1;

mem_access=1;
$display("Initialisation seq executed");
Start_time=$time;
end
end

always @(posedge Decrmt_enbl)
    begin
      Mpl_scan_enbl=1;
    end

always @(posedge Rset_hit_fnd_flg)
    begin
    Hit_fnd_flag=0;
    mem_access=1;
    end

always @ (negedge Clk)
  begin
    if  (! End_scan_flag)
      begin
      Hit_fnd_ORed_flg=|Hit_lst_buffr;

      if (!.Hit_fnd_ORed_flg)
        begin
        End_scan_flag=1;
        Mpl_scan_enbl=0;.
        end
      end

    if ((Mpl_scan_enbl) && ( Hit_fnd_ORed_flg))
      begin
        if (decrmt_enbl1)
          begin
            if (Hit_lst_buffr[pos1]==1)
                begin
                  Hit_lst_buffr[pos1]=0;
                  decrmt_enbl1=0;.
                  if (!mem_access )
                   begin
                   c1=c1+1;
                   $display("Clash1 c1=%d",c1);
                   end
                  wait(mem_access);
                  mem_access=0;
                  Num_hits=Num_hits + 1;
                  Fan_out_size_reg=Fan_out_size_tbl[pos1];
```

```
                    Fan_out_src_reg=Fan_out_hdr_tbl[pos1];
                    Hit_fnd_flag=1;
                    Hit_lst_buffr[pos1]=0;

                    if (pos1 >lwr_lt1)
                       begin
                       pos1=pos1-1;
                       decrmt_enbl1=1;
                       end

              end
           else
             begin
                  if (pos1 >lwr_lt1)
                   begin
                   pos1=pos1-1;
                   end
                  else
                   decrmt_enbl1=0;
             end
          end


          --------------------

       if (decrmt_enbl30)
          begin
            if (Hit_lst_buffr[pos30]==1)
               begin
                  Hit_lst_buffr[pos30]=0;
                  decrmt_enbl30=0;
                  if (!mem_access )
                   begin
                   c30=c30+1;
                   $display("Clash30 c30=%d",c30);
                   end
                  wait(mem_access);
                  mem_access=0;

                  Num_hits=Num_hits + 1;
                  Fan_out_size_reg=Fan_out_size_tbl[pos30];
                  Fan_out_src_reg=Fan_out_hdr_tbl[pos30];
                  Hit_fnd_flag=1;
                  Hit_lst_buffr[pos30]=0;

                  if (pos30 >lwr_lt30)
                     begin
                     pos30=pos30-1;
                     decrmt_enbl30=1;
                     end

                end
             else
               begin
                    if (pos30 >lwr_lt30)
                     begin
                     pos30=pos30-1;
                     end
                    else
                     decrmt_enbl30=0;
               end
            end

         end

      end


   always @(posedge End_scan_flag)
```

```
       begin
       Finish_time=$time;
       end
    endmodule
```

## Fan-out Generator module

**Description: When a hit has been detected in the Group-test Hit list. The address within the scan register selects a vector (from the Fan-out hdr table) which locates the start of a fan-out list for the current active gate. The address register of this module is loaded with the address of the header of the fan-out list. The size of this fan-out list and the updated signal value to be transmitted is also conveyed to the module. The module proceeds to affect all changes in the fan-out lists.**

```
    module Fan_out_gen(Fan_out_load,Fan_out_gen_flg,Reset_gen,Update_val_in,
                    Clock,Update_val_out,Fan_out_size_reg,
                    Fan_out_adr_reg,Out_adr_reg);

    //The address in   Fan_out_vector_tbl of the header of the Fan-out list and the
    number of fan-out elements, are contained in Fan_out_adr_reg and Fan_out_size_reg
    respectively. These are loaded on the positive edge of Fan_out_load. On the
    successive negative edge(s) of Clock the address of a fan-out wire is generated in
    Out_adr_reg. The end of a fan-out list is indicated when Fan_out_gen_flg is set.
    This flag is cleared by the positive edge of Reset_gen. The signal value to be
    conveyed to the fan-out list is transferred to and transmitted by the module in
    Update_val_in and Update_val_out, respectively.//

    parameter Vectr_tbl_wrd_size = 13;
    parameter Vectr_tbl_size = 16383;
    parameter Inp_val_wdth=2;
    parameter Max_fan_out=7;
    parameter Vectr_tbl_adr_size=13;

    input Fan_out_load,Reset_gen,Clock;
    input [Inp_val_wdth:0] Update_val_in;
    input [Max_fan_out:0] Fan_out_size_reg;
    input [Vectr_tbl_adr_size:0] Fan_out_adr_reg;

    output Fan_out_gen_flg;
    reg Fan_out_gen_flg;

    output [Inp_val_wdth:0] Update_val_out;
    reg [Inp_val_wdth:0] Update_val_out;

    output [Vectr_tbl_wrd_size:0] Out_adr_reg;
    reg [Vectr_tbl_wrd_size:0] Out_adr_reg;


    reg[Vectr_tbl_wrd_size:0] Fan_out_vector_tbl[0:Vectr_tbl_size];

    reg[Vectr_tbl_wrd_size:0] List_pos;

    reg[Max_fan_out:0] Counter;


    initial $readmemh("Fanvcr.dat", Fan_out_vector_tbl);
    //Fanvcr.dat contains the vectors of the signals in the fan-out lists for every
    gate.//

    initial forever
    begin
     @(Reset_gen)
```

27

```
  if (Reset_gen)
    begin
    Fan_out_gen_flg=0;
    end
end

always @(posedge Fan_out_load)
 begin
 if (!Reset_gen)
  begin
  Counter=Fan_out_size_reg;
  List_pos=Fan_out_adr_reg;
  Update_val_out=Update_val_in;
  Fan_out_gen_flg=1;
  end
 end


always @(negedge Clock)
 begin
 if (!Reset_gen && Fan_out_gen_flg)
  begin

  if (Counter>0)
    begin
    Out_adr_reg=Fan_out_vector_tbl[List_pos];
    List_pos=List_pos+1;
    Counter=Counter-1;
    end
  else
    Fan_out_gen_flg=0;

  end
 end
endmodule
```

## Input-value Bank

Description: The bank contains the current values of all the signals in the circuit. Each location in the bank corresponds to a wire. Since a word at any location is 3 bits wide, up to 8-valued logic can be simulated (this can be augmented by increasing the word width). The current value of any wire is shifted from this bank into Array_1b when time is incremented. This is done in parallel. Only wire values that have changed in the current time interval are updated.

```
module Input_val_bank(Inp_val_reg, Adr_reg,Clock,Shft_enbl,Wrt_enbl,
                      Out_buffr_reg);
//Inp_val_reg contains the new value of a signal(i.e. word) in Inp_val_ary. The
location of the wire is specified in Adr_reg and the write operation takes effect
on the negative edge of Clock if Wrt_enbl is asserted. If Shft_enbl is asserted
then the right-most bit of every location is shifted into the 1-bit column-
register Out_buffr_reg on the positive edge of Clock. All shifted bits are also
written into the right-most bit of Inp_val_ary (i.e a rotation); thus all current
values have been retained after the shifting out process. //

parameter Inp_val_wdth=2;
parameter Adr_reg_bits=13;
parameter Inp_bnk_size=16383;
parameter Lsr7552_Inp_bnk_size=8784;

input Clock,Shft_enbl,Wrt_enbl;
input[Inp_val_wdth:0] Inp_val_reg;
input[Adr_reg_bits:0] Adr_reg;

output[Inp_bnk_size:0] Out_buffr_reg;
reg [Inp_bnk_size:0] Out_buffr_reg;

reg [Inp_val_wdth:0] Inp_val_ary[0:Inp_bnk_size];

reg [Inp_val_wdth:0] Temp_reg;
reg Temp_bit;

integer Inp_ary_indx,i;

initial $readmemb("Inpval.dat",Inp_val_ary);
//Inpval.dat is the file which initialises the current input values of all gates
in the simulated circuit. All values are assigned 'Unknown' logic values except
those primary inputs which are assigned logic '0' or '1'.//

always @(posedge Clock)
    begin
       if (Shft_enbl)
        begin
            for (Inp_ary_indx=0; Inp_ary_indx<=Lsr7552_Inp_bnk_size;
                                 Inp_ary_indx=Inp_ary_indx+1)
            begin
              Temp_reg=Inp_val_ary[Inp_ary_indx];
              Temp_bit=Temp_reg[0];
              Out_buffr_reg[Inp_ary_indx]=Temp_bit;
              Temp_reg[1:0]=Temp_reg[Inp_val_wdth:1];
              Temp_reg[Inp_val_wdth]=Temp_bit;
              Inp_val_ary[Inp_ary_indx]=Temp_reg;
            end
            $display("(shft)time=%d",$time);
        end

        else
```

```
            if (Wrt_enbl)
               begin
               Inp_val_ary[Adr_reg]=Inp_val_reg;
               end
        end
endmodule
```

# The  Sequence Logic of the APPLES Processor

```
parameter Nibl=3;
parameter Ary_la_wdth=7;
parameter Ary_1b_adr_reg_wdth=13;
parameter Ary_la_size=16383;
parameter Ary_1b_size=16383;
parameter Eval_ptrn_tbl_size=63;
parameter Eval_ptrn_vctr_tbl_size=31;
parameter Num_tst_wdth=7;
parameter Num_tst_ptrn_tbl_size=31;
parameter Gate_maskla_tbl_size=31;
parameter Gate_inptla_tbl_size=31;
parameter Trr_ptrn_tbl_size=31;
parameter Grr_ptrn_tbl_size=31;
parameter Out_val_tbl_size=31;


parameter Wlr_wrdsize=31;
parameter Trr_wdth_spec=2;
parameter Trr_word_size=7;
parameter Grr_mem_size=8191;
parameter Grr_wdth_spec=2;
parameter Grr_word_size=7;
parameter Iu_word_size=7;
parameter Iu_wdth_spec=2;
parameter Vectr_tbl_adr_reg=13;
parameter Max_fan_out=7;
parameter Inp_val_wdth=2;
parameter Vectr_tbl_adr_size=16383;

parameter Index_reg_wdth=7;
parameter Num_tst_seq=12;   //No of gates X No Transitions
parameter Num_tst_cnt_wdth=3;
parameter Init_shft_val=3;
parameter Shft_cnt_wdth=3;

wire Clock;
wire[Ary_la_size:0] Wrd_ln_activ_lst,Trr_bnk_inp_reg;
wire[Ary_1b_size:0] Inval_unit_out_reg;
wire[Grr_mem_size:0] Grr_bnk_inp_reg,Grr_bnk_hit_lst;
wire[Max_fan_out:0] Mrr_unit_fan_out_size_reg;
wire[Vectr_tbl_adr_reg:0]   Mrr_unit_fan_out_src_reg;
wire[Inp_val_wdth:0] Fo_gen_unit_val_out;
wire[Vectr_tbl_adr_size:0] Fo_gen_unit_out_adr_reg;

reg Tst_seq_strt;
reg e0,e1,e2,e3,e4,e5,e6,e7,e8,e9,e10,e11,e12,e13,e14,
    e15,e16,e16a,e16b,e17,e18,e19,e20,e21,e22,e23,e24,e25,e26,e27,e28,e29,
    Deact_srchla,Gate_eval_init_proc;

reg[Index_reg_wdth:0]    Ept_i,Epvt_i,Ntpt_i,Gmlat_i,Gilat_i,
                         Tpt_i,Grit_i,Grmt_i,Ovt_i;

reg[Wlr_wrdsize:0]  Eval_ptrn_tbl[0:Eval_ptrn_tbl_size];
reg[Wlr_wrdsize:0]  Eval_ptrn_vctr_tbl[0:Eval_ptrn_vctr_tbl_size];
reg[Num_tst_wdth:0] Num_tst_ptrn_tbl[0:Num_tst_ptrn_tbl_size];
reg[Ary_la_wdth:0]  Gate_maskla_tbl[0:Gate_maskla_tbl_size];
reg[Ary_la_wdth:0]  Gate_inptla_tbl[0:Gate_inptla_tbl_size];
reg[Trr_word_size:0] Trr_ptrn_tbl[0:Trr_ptrn_tbl_size];
reg[Grr_word_size:0] Grr_inpt_tbl[0:Grr_ptrn_tbl_size];
```

EP 1 192 570 B1

```
reg(Grr_word_size:0] Grr_mask_tbl[0:Grr_ptrn_tbl_size];
reg[Inp_val_wdth:0]  Out_val_tbl[0:Out_val_tbl_size];

reg[Grr_word_size:0] Grr_bnk_search_reg,Grr_bnk_mask_reg;

reg[Grr_wdth_spec:0] Grr_bnk_wrt_pos;

reg[Trr_wdth_spec:0] Trr_bnk_wrt_pos;
reg[Trr_word_size:0] Trr_rslt_act_reg,Trr_rslt_act_and_0;

reg[Iu_word_size:0] Inval_unit_adr_reg;
reg[Iu_wdth_spec:0] Fo_gen_unit_val_in,Inval_unit_in_reg;

reg Search_ary_1a,Write_enbl_1a,Ary_1b_wrt_enbl,Wlr_bnk_search_enbl,Shft_ary_1b,
    Ary_1b_rd_enbl,Trr_bnk_wrt_enbl,Trr_bnk_comb_enbl,Trr_bnk_rset,
    Grr_bnk_search_enbl,Grr_bnk_wrt_enbl,Mrr_unit_rset,Mrr_unit_decrmt_enbl,
    Mrr_unit_rset_hit_fnd_flg,Fo_gen_unit_load,Fo_gen_unit_rset,
    Inval_unit_shft_enbl,Inval_unit_wrt_enbl;

reg[Ary_1a_wdth:0] Inp_regla, Mask_regla,Adr_regla;

reg[Wlr_wrdsize:0] Inp_reg_1b,Search_reg_1b,Mask_reg_1b;

reg[Ary_1b_adr_reg_wdth:0] Adr_reg_1b;

reg[Num_tst_cnt_wdth:0] Num_tst_cnt;

reg[Shft_cnt_wdth:0] Shft_cnt;


Ary_1a  Gate_id_bnk(Inp_regla,Mask_regla,Adr_regla,Clock,
                    Search_ary_1a,Write_enbl_1a, Wrd_ln_activ_lst);

Ary_1b   Wrd_ln_reg_bnk(Search_reg_1b, Mask_reg_1b,Adr_reg_1b,
                    Inp_reg_1b,Out_reg_1b,Trr_bnk_inp_reg,Shft_ary_1b,
                    Wlr_bnk_search_enbl,Ary_1b_wrt_enbl,Ary_1b_rd_enbl,
                    Clock,Inval_unit_out_reg,Wrd_ln_activ_lst);

Tst_rslt_reg_bank Trr_bnk(Trr_bnk_inp_reg,Trr_bnk_wrt_enbl,Trr_bnk_comb_enbl,
                    Clock,Grr_bnk_inp_reg,Trr_rslt_act_reg,
                    Trr_bnk_wrt_pos,Trr_bnk_rset);

Grp_rslt_reg_bank Grr_bnk(Grr_bnk_inp_reg,Grr_bnk_mask_reg,
                    Grr_bnk_search_reg,Clock,Grr_bnk_search_enbl,
                    Grr_bnk_wrt_enbl,Grr_bnk_wrt_pos,Grr_bnk_hit_lst);

Multiple_res_res   Mrr_unit(Grr_bnk_hit_lst,Clock,Mrr_unit_rset,
                    Mrr_unit_end_scan_flg,Mrr_unit_decrmt_enbl,
                    Mrr_unit_fan_out_src_reg,
                    Mrr_unit_fan_out_size_reg,
                    Mrr_unit_rset_hit_fnd_flg,
                    Mrr_unit_hit_fnd_flag);

Fan_out_gen  Fo_gen_unit(Fo_gen_unit_load,Fo_gen_unit_flg,Fo_gen_unit_rset,
                    Fo_gen_unit_val_in,Clock,Fo_gen_unit_val_out,
                    Mrr_unit_fan_out_size_reg,Mrr_unit_fan_out_src_reg,
                    Fo_gen_unit_out_adr_reg);

Input_val_bank   Inval_unit(Fo_gen_unit_val_out,Fo_gen_unit_out_adr_reg,Clock,
                    Inval_unit_shft_enbl,Inval_unit_wrt_enbl,
                    Inval_unit_out_reg);

Ck_gen    Clk_unit(Clock);


integer i,Tst_num,iter_cnt;
```

31

```
initial
 begin
  $display("Initialisation commencing.");
  $readmemh("Ep_tbl.dat",Eval_ptrn_tbl);
  $display("Ep_tbl.dat loaded.");
  $readmemh("Epv_tbl.dat",Eval_ptrn_vctr_tbl);
  $display("Epv_tbl.dat loaded.");
  $readmemh("Ntp_tbl.dat",Num_tst_ptrn_tbl);
  $display("Ntp_tbl.dat loaded.");
  $readmemh("Gi1a_tbl.dat",Gate_inpt1a_tbl);
  $display("Gi1a_tbl.dat loaded.");
  $readmemh("Gm1a_tbl.dat",Gate_mask1a_tbl);
  $display("Gm1a_tbl.dat loaded.");
  $readmemh("Tp_tbl.dat",Trr_ptrn_tbl);
  $display("Tp_tbl.dat loaded.");
  $readmemh("Gi_tbl.dat",Grr_inpt_tbl);
  $display("Gi_tbl.dat loaded.");
  $display("Gi_tbl.dat loaded.");
  $readmemb("Gm_tbl.dat",Grr_mask_tbl);
  $display("Gm_tbl.dat loaded.");
  $readmemb("Ov_tbl.dat",Out_val_tbl);
  $display("Ov_tbl.dat loaded.");
  $display("Table initialisation sequence completed");

  Gate_eval_init_proc=1;
  iter_cnt=0;
  Num_tst_cnt=Num_tst_seq;
  Inval_unit_shft_enbl=0;
  Ept_i=8'h00; Epvt_i=8'h00; Ntpt_i=8'h00;
  Gm1at_i=8'h00; Gi1at_i=8'h00; Tpt_i=8'h00;
  Grit_i=8'h00; Grmt_i=8'h00; Ovt_i=8'h00;
 end

 always @(negedge Clock)
  if (Gate_eval_init_proc)
   begin
    $display("Gate_eval_init_proc @ time=%d",$time);
    iter_cnt=iter_cnt+1;
    $display("Iteration count=%d",iter_cnt);
    Gate_eval_init_proc=0;
    Deact_srch1a=0;

    e0=0; e1=0; e2=0; e3=0; e4=0; e5=0; e6=0;
    e7=0; e8=0; e9=0; e10=0; e11=0; e12=0; e13=0;
    e14=0; e15=0; e16=0; e16a=0; e16b=0; e17=0;
    e18=0; e19=0; e20=0; e21=0; e22=0;

    Inp_reg1a=Gate_inpt1a_tbl[Gi1at_i];
    Mask_reg1a=Gate_mask1a_tbl[Gm1at_i];
    Tst_num=Num_tst_ptrn_tbl[Ntpt_i];
    Ept_i=Eval_ptrn_vctr_tbl[Epvt_i];
    Mrr_unit_decrmt_enbl=0;
    Tst_seq_strt=1;
    Wlr_bnk_search_enbl=0;
    Inval_unit_wrt_enbl=0;
   end

 always @(posedge Clock)
   begin
    if (Tst_seq_strt)
     begin
     Trr_bnk_rset=1;
     Search_ary_la=1;
     e0=1;
     Tst_seq_strt=0;
     end
    end
```

```
always @(negedge Clock)
 begin
 if (e0)
   begin
   e0=0;
   Deact_srch1a=1;
   end
 end


always @(posedge Clock)
  begin
  if (Deact_srch1a)
    begin
    Trr_bnk_rset=0;
    Deact_srch1a=0;
    Search_ary_1a=0;
    e1=1;
    i=Trr_word_size;
    end
  end


always @(negedge Clock)
  begin
  if (e1)
    begin
    e1=0;
    e2=1;
    end
  end


always @(posedge Clock)
  begin
  if (e2)
    begin
    Wlr_bnk_search_enbl=1;
    Search_reg_1b=Eval_ptrn_tbl[Ept_i];
    Mask_reg_1b=Eval_ptrn_tbl[Ept_i+1];
    e2=0;
    e3=1;
    end
  end

always @(negedge Clock)
  begin
  if (e3)
    begin
    e3=0;
    e4=1;
    end
  end


always @(posedge Clock)
  begin
  if (e4)
    begin
    Trr_bnk_wrt_enbl=1;
    Trr_bnk_wrt_pos=i;
    Wlr_bnk_search_enbl=0;
    e4=0;
    e5=1;
    end
  end
```

```verilog
always @(negedge Clock)
  begin
  if (e5)
    begin
    e5=0;
    e6=1;
    end
  end


always @(posedge Clock)
  begin
  if (e6)
     begin
      Tst_num=Tst_num-1;
      i=i-1;
      e6=0;
      if (Tst_num> 0)
         begin
         e1=1;
         Ept_i=Ept_i+2;
         $display("Ept_i (updated)=%d",Ept_i);
         Trr_bnk_wrt_enbl=0;
         end
      else
         begin
         Trr_bnk_wrt_enbl=0;
         i=Trr_word_size;
         Trr_rslt_act_reg=Trr_ptrn_tbl[Tpt_i];
         Tst_num=Num_tst_ptrn_tbl[Ntpt_i];
         e7=1;
         end
     end
  end

always @(negedge Clock)
  begin
  if (e7)
    begin
    e7=0;
    e8=1;
    end
  end


always @(posedge Clock)
  begin
  if (e8)
     begin
     Trr_bnk_comb_enbl=1;
     Trr_bnk_wrt_pos=i;
     e8=0;
     e9=1;
     $display("Commencement of TRR tests for Gate type=%b",Inp_regla,"at
              time=%d",$time);
     end
  end

always @(negedge Clock)
  begin
  if (e9)
    begin
    e9=0;
    e10=1;
    end
  end
```

```
always @(posedge Clock)
   begin
    if (e10)
       begin
       Trr_bnk_comb_enbl=0;
       Grr_bnk_wrt_enbl=1;
       Grr_bnk_wrt_pos=i;
       e10=0;
       e11=1;
       end
   end

always @(negedge Clock)
   begin
   if (e11)
      begin
      e11=0;
      e12=1;
      end
   end

always @(posedge Clock)
   begin
   if (e12)
     begin
       Tst_num=Tst_num-1;
       i=i-1;
       e12=0;
       if (Tst_num>0)
         begin
         e9=1;
         Trr_bnk_comb_enbl=1;
         Trr_bnk_wrt_pos=i;
         Grr_bnk_wrt_enbl=0;
         end
       else
         begin
         e13=1;
         Grr_bnk_wrt_enbl=0;
         end
     end
   end

always @(negedge Clock)
   begin
   if (e13)
      begin
      e13=0;
      e14=1;
      $display("Termination of Trr tests for Gate type=%b",Inp_reg1a,"at
               time=%d",$time);
      end
   end

always @(posedge Clock)
   begin
   if (e14)
      begin
      Grr_bnk_search_reg=Grr_inpt_tbl[Grit_i];
      Grr_bnk_mask_reg=Grr_mask_tbl[Grmt_i];
      Grr_bnk_search_enbl=1;
      Fo_gen_unit_rset=1;
      e14=0;
      e15=1;
      end
   end
```

35

```
always @(negedge Clock)
  begin
  if (e15)
    begin
    e15=0;
    e16=1;
    end
  end

always @(posedge Clock)
  begin
  if (e16)
    begin
    Mrr_unit_rset=1;
    e16=0;
    e16a=1;
    end
  end

always @(negedge Clock)
  begin
  if (e16a)
    begin
    Mrr_unit_rset=0;
    e16a=0;
    e16b=1;
    end
  end

// Propagate values to gates affected in fan_out lists.

always @(posedge Clock)
  begin
  if (e16b)
    begin
    Grr_bnk_search_enbl=0;
    Mrr_unit_decrmt_enbl=1;
    Fo_gen_unit_rset=0;
    Fo_gen_unit_val_in=Out_val_tbl[Ovt_i];
    e16b=0;
    e17=1;
    $display("Start of fanout list at time=%d",$time);
    end
  end

always @(negedge Clock)
  begin
  if (e17)
    begin
    Fo_gen_unit_load=0;
    e17=0;
    e18=1;
    end
  end


always @(posedge Clock)
  begin
  if (e18)
    begin
      if (Mrr_unit_hit_fnd_flag)
        begin
         Fo_gen_unit_load=1;
         e18=0;
         e19=1;
        end
```

```
           else

              if((!Mrr_unit_hit_fnd_flag) & (Mrr_unit_end_scan_flg))
                 begin
                    e18=0;
                    e22=1;
                    Mrr_unit_decrmt_enbl=0;
                 end



              end
           end

        always  @(negedge Clock)
           begin
            if (e19)
             begin
              Fo_gen_unit_load=0;
              Inval_unit_wrt_enbl=1;
              Mrr_unit_rset_hit_fnd_flg=0;
              e19=0;
              e20=1;
             end
           end

        always @(posedge Clock)
           begin
            if (e20)
             begin
              if ( ! Fo_gen_unit_flg )
                 begin
                  if (! Mrr_unit_end_scan_flg)
                   begin
                    Mrr_unit_rset_hit_fnd_flg=1;
                    Inval_unit_wrt_enbl=0;
                    e20=0;
                    e21=1;
                   end

                 else

                    begin
                     Inval_unit_wrt_enbl=0;
                     e20=0;
                     e22=1;
                    end
                 end
              end
           end

        always @(negedge Clock)
           begin
            if (e21)
              begin
                 e18=1;
                 e21=0;
              end
           end

        always @(negedge Clock)
           begin
            if (e22)
              begin
                 e22=0;
                 e23=1;
                 Epvt_i=Epvt_i+1; Ntpt_i=Ntpt_i+1;
                 Gmlat_i=Gmlat_i+1; Gilat_i=Gilat_i+1;
```

```
        Tpt_i=Tpt_i+1;
        Grit_i=Grit_i+1;  Grmt_i=Grmt_i+1;
        Ovt_i=Ovt_i+1;
        $display("Termination of Fan out update, time=%d", $time);
      end
    end

always @(posedge Clock)
  begin
   if (e23)
    begin
     e23=0;
     Num_tst_cnt=Num_tst_cnt-1;
       if (Num_tst_cnt==0)
       begin
       e24=1;
       end
     else
       Gate_eval_init_proc=1;
    end
  end

always @(negedge Clock)
  begin
   if (e24)
    begin
     $display("E24 attained,End of fanout update. ");
     $display("-----------------------");
     Inval_unit_shft_enbl=1;
     Shft_cnt=Init_shft_val;
     e24=0;
     e25=1;
    end
  end

// Input_val_bank is +ve edge triggered. Thus next block is -ve edge.

always @(posedge Clock)
  begin
   if (e25)
    begin
     $display("E25 attained ");
     Shft_ary_1b=1;
     e25=0;
     e26=1;
    end

  end

always @(negedge Clock)
  begin
   if(e26)
    begin
     $display("E26 attained ");
     Shft_cnt=Shft_cnt-1;
     if (Shft_cnt==0)
       begin
        e26=0;
        Inval_unit_shft_enbl=0;
        e27=1;
       end
    end
  end

always @(posedge Clock)
  begin
   if (e27)
     begin
```

```
        Shft_ary_1b=0;
        e27=0;
        e28=1;
        end
    end

always @(negedge Clock)
    begin
     if (e28)
      begin
       e28=0;
       e29=1;
      end
    end

always @(posedge Clock)
    begin
     if (e29)
      begin
       Gate_eval_init_proc=1;
       Num_tst_cnt=Num_tst_seq;
       Ept_i=8'h00; Epvt_i=8'h00; Ntpt_i=8'h00;
       Gmlat_i=8'h00; Gilat_i=8'h00; Tpt_i=8'h00;
       Grit_i=8'h00; Grmt_i=8'h00; Ovt_i=8'h00;
       e29=0;
      end
    end

endmodule
```

@@@@@@@@@@@@@@@@@@@@@@@@@@@@@@@@@@@@@

The APPLES architecture is designed to provide a fast and flexible mechanism for logic simulation. The technique of applying test patterns to an associative memory culminates in a fixed time gate processing and a flexible delay model. Multiple scan registers provide an effective way of parallelising the fan-out up-dating procedure. This mechanism eliminates the need for conventional parallel techniques such as load balancing and deadlock avoidance or recovery. Consequently, parallel overheads are reduced. As more scan registers are introduced, the gate evaluation rate increases, ultimately being limited by the average fan-out list size per gate and consequently the memory bandwidth of fan-out list memory.

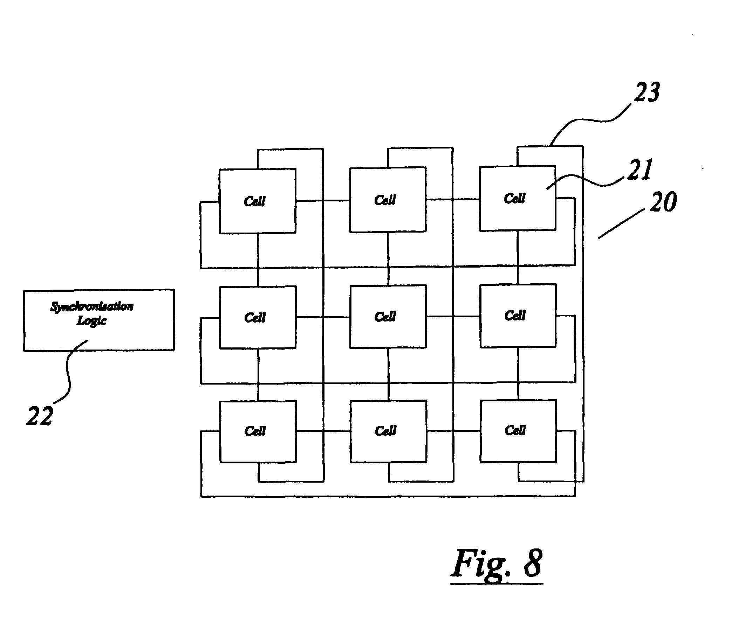

Referring to Fig. 8, there is illustrated an array indicated generally by the reference numeral 20 comprising a plurality of cells 21, each of which comprises an APPLES processor as described above. A synchronisation logic control 22 is provided. The circuit that is to be simulated is split up among the APPLES processor. Gate evaluations are carried out independently in each processor or cell 21. Each cell 21 is provided with a local input value register bank and a foreign input value register bank to allow interconnection which is done through an interconnecting network 23 incorporating the synchronisation logic 22. Connections between the synchronisation logic circuit 22 which is, strictly speaking, the main synchronisation logic circuit, to each of the cells 21 is not shown.

After all gate evaluations for all gate types and the corresponding updates have occurred, on a given processor forming a cell 21, the processor must wait for all other processors to reach the same state. When all processors reach this state then the respective input value register banks can be shifted into the respective array and associative register 1b and evaluation of the next time unit can occur. Thus, to achieve implementation, there is required that a suitable interconnecting network must be designed and an interface to the APPLES processor constructed. A synchronisation method must exist to determine when evaluation of the next time unit should proceed. A system to split the hit list information amongst the processors is required in order to initialise the system.

The array of processors is implemented as a torus (equivalent to a 2D mesh with wrap-around) as shown in Fig. 8. The inclusion of wrap-around connections reduces the network diameter increasing the network speed. It also means that each processor can be identical without wasted hardware at the edges of the array. It does however require a more complicated routing mechanism. No set size was used for the array instead the size was used as a criteria which was varied during simulations. This criterion was specified by a command line parameter to the Verilog compiler. These command line parameters are covered in detail in the next chapter.

Each cell is connected to its four neighbouring cells via serial connections. Obviously parallel connections would be faster. However a Virtex FPGA was used and it has a limited number of pins. It may happen that not all of these pins are available to a particular design due to the FPGA architecture. Pins are therefore a precious resource. Since each FPGA would require eight parallel connections (an input and an output connection on each of the four edges) this would require a large number of pins. If at a later stage it is discovered that there are spare pins and a parallel network is justified then the design could be altered. In this design each cell has a serial input and a serial output on each of its four edges. These serial connections each consist of a data line and two control lines. These serial connections will therefore require 12 pins on each Virtex FPGA. Each cell is also connected to the array's synchronisation logic.

In order to design the network knowledge of the information that the network must carry is required. The network is required in order to pass fan out updates between processors. These updates can be passed as messages. Each message is an update and consists of a destination address and an update value. A single Virtex FPGA was used to implement an APPLES processor capable of simulating a circuit with approximately 256 gates. This figure is somewhat arbitrary and further design work will reveal the true value required. Given a restraint of 256 gates per processor approximately 64 processors would be required to simulate a reasonably complex circuit. This corresponded to an 8 x 8 array. Each processor will need to be able to send updates to any other processor updating any one of their 512 gate inputs. This implies an address space of six to identify the processor and an address space of nine to identify the wire. Each update sent also requires an update value. These are three bits wide (enabling support for eight-state logic). Therefore messages sent from processor to processor will need to be eighteen bits wide. These figures are arbitrary but are a useful starting point.

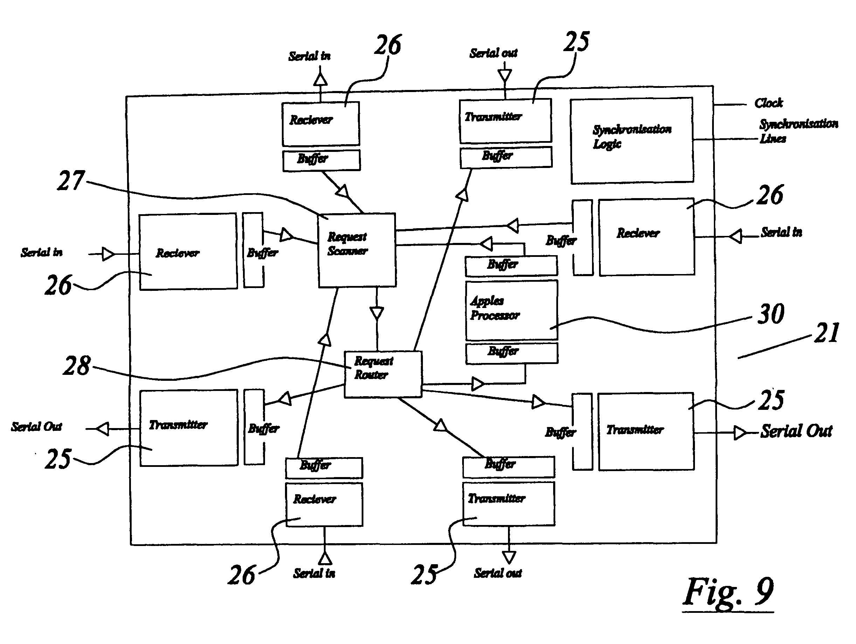

The structure of a cell 21 is shown in Fig. 9. Each of the four edges has a transmitter 25 and a receiver 26. These modules deal with the serial connections. The transmitter 25 takes in an eighteen-bit entity and sends it out in a bit stream. The receiver 26 takes in the bit stream and reconstitutes it into the original eighteen-bit message.

A request scanner 27 checks every receiver 26 and the APPLES processor 30 simultaneously to see if they have messages waiting to be routed. It assigns each of these sources a rotating priority and picks the source that has a message and the highest priority. It then passes the picked message to a request router 28.

The request router 28 passes its messages either to the APPLES processor 30 or to a transmitter 25. If the option chosen is a transmitter then the message will be sent to a different cell 21. If the option chosen is the APPLES processor 30 then the message is an update for the local processor. A synchronisation logic circuit 31 controls the cell 21 through the synchronisation logic circuit 22.

In Fig. 9 every transmitter, every receiver and the input and output ports of the APPLES processor have buffers connected. A command line parameter to the Verilog compiler specifies whether these components are to be used or removed from the design. One slightly different behaviour of these buffers is that they process data in a LIFO fashion. The effect of these buffers on performance is an important part of the system analysis.

The request router 28 employs one of two different routing techniques. The technique used is determined by a command line parameter to the Verilog simulator used to implement the invention. A comparison of the routing techniques is important to the understanding of the invention. Both routing techniques operate in a similar manner.

The request router 28 decodes the message. It can then determine the destination processor. It determines all the valid options for routing the message. The message could be routed to the local APPLES processor 30 or to one of the transmitters 25. The message is then routed to one of the valid options.

The first routing technique only produces one valid routing option and if that route is not blocked then the message is routed in that direction. If it is blocked then the request router 28 attempts to route a different message. Messages are passed from cell 21 to cell 21 until they reach their destination. Under this routing technique a message is passed first either in the east or west direction until it is at the correct east-west location. It is then routed in the north or south direction until the message arrives at its destination. The net result of the message passing is that the message travels the minimum distance. This routing strategy results in the traffic between any two given cells 21 always following the same route through the network. This routing strategy can be called standard routing.

The second routing technique is more complicated. Under this strategy the request router 28 determines all of the available directions that can be taken by the message which will result in it travelling the shortest distance. The various options have different priorities associated with them. This priority is based on the options that were previously taken. This priority method helps to use the various routes evenly and therefore efficiently. Some of the options may not be feasible as they may be in use with previous messages. An option is chosen based on priority and availability. The priority information is then updated. This routing strategy is an advanced routing.

For both routing techniques, when all valid paths are blocked and the request router 28 is unable to route its message then it simply drops the message. This is an important aspect to the manner in which the request scanner 27 and request router 28 work together. The request scanner 27 takes a message from one of its sources. It does not inform the source that it is attempting to route this message. The source maintains the message at its output. If the request router 28 successfully routs the message then it tells request scanner 27 that it has done so and the request scanner 27 informs the source. This way the request router 28 is not committed to routing a particular message. The request router 28 therefore is always free to attempt to route messages.

The network interface 42 shares access to the input value register bank 20 between the local processor and the network. The local processor gets priority. This module decodes the message and updates the appropriate location in the input value register bank 2.

The network interface 42 is connected between the fan out generator 43 and the I Input value register bank 2. It can therefore pass fan out updates from the processor to the network when appropriate or simply pass them to the input value register bank 2. It can also pass fan out updates from the network to the input value register bank 2. Some changes were required in the fan out generator 43 to accommodate the network interface 42.

When each processor in the array has processed the fan out list for each of its active gates and all updates have reached their destination then each processor can shift its input value register bank 2 into its array 1b and proceed with evaluation of the next time unit. In order to achieve this some synchronisation logic, between the cells 21, is required. The implementation for this requires each processor to report to its cell 21 when it has completed sending updates. Each cell 21 also monitors the network activity and reports back to the array stating whether there is network activity or processor activity. The array therefore knows when all processors are finished updating and when the network is empty. At such a time the array reports back to the cells 21. Then the cells 21 tell the processors to proceed with the next time unit in the delay model. The implementation of this system required minor changes in the sequence logic of the APPLES processor.

The network is not used to communicate this synchronisation information. Instead dedicated wires are provided. Each cell 21 has a finished input wire and a finished output wire. The cell 21 holds the finished output wire high when its processor has finished and no network activity is occurring around the cell 21. The finished input wire is controlled by the array synchronisation logic. The array holds it high when it detects that all the finished output wires are high at the same time. It would be possible to use the network to communicate this synchronisation information. This would reduce the number of Virtex pins required by the design. However the synchronisation logic would be more complex and require more circuitry. The synchronisation process would also take longer to execute.

The information pertaining to the circuit description is stored in five memories within an APPLES processor. Under the basic APPLES Verilog design these memories are loaded from data files using the $READMEM system command. For the system to be implemented on a Virtex chip these memories could be loaded via a PCI interface.

Under the APPLES array each processor evaluates part of the circuit to be simulated. The contents of these five memories need to be split among the processors in the array. The memory contents also need to be processed in order to make it compatible with the array design. Under an implementation using an array of Virtex chips this data could be loaded via a PCI bus and distributed using the array network. The data would be pre-processed for the array and each processor would simply need to load the data into its memories. The incorporation into the design of a system to distribute this data is non-trivial. This project is mainly concerned with the analysis of the array design's ability to simulate circuits. An analysis of the array's initialisation system is not of paramount importance at this time. As a result the initialisation system was not designed.

In order to initialise the design, to facilitate simulating circuits, a Verilog task was written to load the memories. The single processor circuit description files are loaded into a global memory in the design. Each processor in the array is assigned a number. A processor's number is calculated by multiplying its y co-ordinates by the array width and adding its x co-ordinates. Each processor loads a segment of the global Array 1a, Array 1b, the fan out header table and the fan out size table into its local memory. These segments are of equal size. The segments chosen are based on their processor number. Processor zero takes the first segment, processor one takes the second segment and so on. A segment of the fan out vector table must be loaded also. The segment is determined by looking at the contents of the local fan out size and fan out header tables. The first address to be loaded from the global fan out vector table is the address stored in the first location in the local fan out header table. The last address to be loaded is calculated by adding the address stored in the last entry in the local fan out header table to the last fan out size stored in the final entry in the local fan out size table. The addresses within the fan out header table must be adjusted to point at the new local fan out vector table. This is achieved by subtracting the address stored in the first location in the local fan out header table from each address in the same table. Each gate input address stored in the local fan out vector table must be converted into an array address. An array address consists of the destination processor's x co-ordinates stored in bits fourteen to twelve, the destination processor's y co-ordinates stored in bits eleven to nine and the gate input's local address on the destination processor stored in bits eight to ten.

Using this system the circuit description is split among the processors. No consideration is given to decide which gate is simulated on which processor. The APPLES circuit description files determine where each gate is simulated. The layout of these files is determined by the layout of the iscas-85 net list files that were used to generate the APPLES circuit description files.

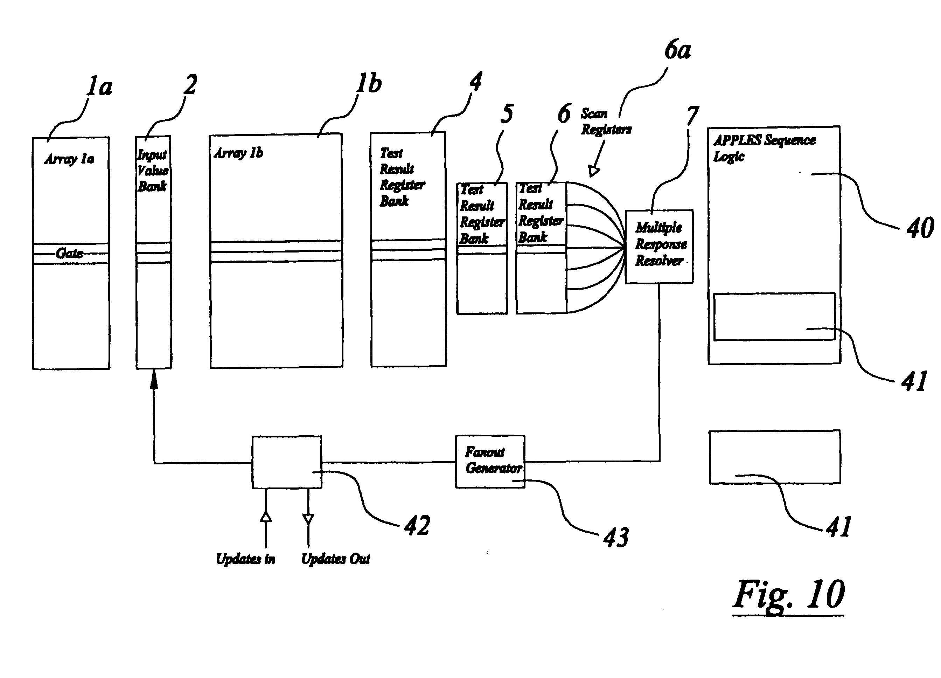

Referring to Fig. 10, there is illustrated an alternative layout of processor in which parts similar to those described with reference to Fig. 1 are identified by the same reference numerals. In this embodiment, the scan registers are identified by the reference numerals 6a and the general logic sequence is identified by the reference numeral 40. The processor will also include a circuit splitting logic circuit 41 and a network interface 42. A fan out generator 43 is identified and will include, for example, the fan out memory 8. The network interface 42 shares access to the input value register bank 2.

The original APPLES design is written in Verilog. So is the array design. The Verilog code is written at a behavioural level. This is the most abstract level available to a Verilog programmer. As with any Verilog system it is split into Verilog modules. Each module is a component of the system. The Verilog modules added under the APPLES array design are:

- The Top Module
- The Array Module
- The Cell Module
- The Receiver Module
- The Transmitter Module
- The Request Scanner Module
- The Request Router Module
- The Buffer Module
- The Network Interface Module

The Top module is used to test that the system is performing correctly. An instantiation of the Top module contains an instantiation of the array module. The array contains multiple instantiations of the Cell module. Each Cell contains four instantiations of both the transmitter and Receiver modules. A Cell also contains a Request Scanner, a Request Router, several buffers and an APPLES processor. The APPLES processor contains instantiations of the standard processor components along with an instantiation of the Network Interface module. This structure and the behaviour of these modules were described earlier in this chapter. Each of these modules is contained within an appropriately named file.

In addition to designing these modules the array design also required the following changes:

- The introduction of a Verilog task to split the circuit description information among the processors in the array. This is located in the APPLES processor module.
- The incorporation of processor synchronisation logic into the APPLES processor module, the Cell module and the Array module.
- The integration of the Network Interface module into the APPLES processor.

The APPLES architecture incorporates an alternative timing strategy which obviates the need for complex deadlock avoidance or recovery procedures and other mechanisms normally part of an event-driven simulation. The present invention has an overhead which is considerably less than conventional approaches and permits gate evaluation to be activated in memory. The reduction in processing overheads is manifest in improved speedup performance relative to other techniques.

A message passing mechanism inherent in the Chady-Misra algorithms has been replaced by a parallel scanning mechanism. This mechanism allows the fan-out/update procedure to be parallelised. As clashes occur gates are effectively put into a waiting queue which fills up an fan-out/update pipeline. Consequently as the pipeline fills up(with the increase number of scan registers), performance increases. The speedup reaches a limit when the new gates entering the queue equals the fan-out rate. Nevertheless, the speedup and the number of cycles per gate processed is considerably better than conventional approaches. The system also allows a wide range of delay models.

The bit-pattern gate evaluation mechanism in APPLES facilitates the implementation of simple and complex delay models as a series of parallel searches. Consequently, the evaluation process is constant in time, being performed in memory. Effectively, there is a one to one correspondence between gate and processor (the gate word pairs). This fine grain parallelism allows maximum parallelism in the gate evaluation phase. Active gates are automatically identified and their fan-out lists updated through scanning a hit-list. This scanning mechanism is analogous to Communication overhead in typical parallel processing architectures, however, this scanning is amenable to parallelisation itself. Multiple scan-registers reduce the overhead time and enable the gate processing rate to be limited solely by the fan-out memory bandwidth. The substantial speedup of the logical simulation with the APPLES architecture is attained resulting in a gate processing rate of a few machine cycles.

The invention is not limited to the embodiments hereinbefore described. The invention is only limited in the appended claims.

**Claims**

1. A parallel processing method of circuit logic simulation comprising representing signals on a line over a time period as a bit sequence, evaluating the output of any logic gate including an evaluation of any inherent delay by a comparison between the bit sequences of the inputs of the logic gate to a predetermined series of bit patterns and in which those logic gates whose outputs have changed over the time period are identified during the evaluation of the gate outputs as real gate changes and only those real gate changes are propagated to the fan out gates of those logic gates,

   the control of the method is carried out in an associative memory mechanism (1a, 1b) which stores in word form a history of gate input signals , a word corresponding to a particular wire and being associated with a gate type, by compiling a hit list register of logic gate state changes and using a multiple response resolver (7) forming part of the associative memory mechanism (1a, 1b) which generates an address for each hit, and then scans and transfers the results on the hit list to an output register for subsequent use **characterised in that** the associative register (1b) is divided into separate smaller associative sub-registers, one type of logic gate being allocated to each associative sub-register, each of which associative sub-registers has corresponding sub-registers connected thereto whereby gate evaluations and tests are carried out in parallel on each associative sub-register.

2. A method as claimed in claim 1, in which each delay is stored as a delay word in an associative memory (1b) forming part of the associative memory mechanism (1a, 1b) in which:-

   the length of the delay word is ascertained; and

   if the delay word width exceeds the associative register (1b) word width:-

   the number of integer multiples of the register word width contained within the delay word is calculated as a gate state;

   the gate state is stored in a further state register (1 a);

   the remainder from the calculation is stored in the associative register (1b) with those delay words whose widths did not exceed the associative register word width; and

   on the count of the associative register commencing:-

   the state register (1 a) is consulted for the delay word entered in the state register and the remainder is ignored for this count of the associative register;

   at the end of the count of the associative register, the state register is updated; and

   the count continues until the remainder represents the count still required.

3. A method as claimed in claim 1 or 2 in which the hit list is segmented into a plurality of separate smaller hit lists, each connected to a separate scan register and in which each scan register is operated in parallel to transfer the results to the output register.

4. A method as claimed in any of claims 1 to 3 in which each line signal to a target logic gate is stored as a plurality of bits each representing a delay of one time period, the aggregate bits representing the delay between signal output to and reception by the target logic gate and in which the inherent delay of each logic gate is represented in the same manner.

5. A method as claimed in any of claims 1 or 4 in which each associative sub-register is used to form a hit list connected to a corresponding separate scan register.

6. A method as claimed in any of claims 1 to 5 in which where the number of the one type of logic gate exceeds a predetermined number more than one sub-register is used.

7. A method as claimed in any of claim 3 to 6 in which the scan registers are controlled by exception logic using an OR gate whereby the scan is terminated for each register on the OR gate changing state thus indicating no further matches.

8. A method as claimed in claim 7 in which the scan is carried out by sequential counting through the hit list and the steps are performed of:

checking if the bit is set indicating a hit;

if a hit, determining the address effected by that hit;

storing the address;

clearing the bit in the hit list;

moving to the next position in the hit list; and

repeating the above steps until the hit list is cleared.

9. A method as claimed in any preceding claim, in which each line signal to a target logic gate is stored as a plurality of bits each representing a delay of one time period, the aggregate bits representing the delay between signal output to and reception by the target logic gate.

10. A method as claimed in any preceding claim in which there is an initialisation phase in which:

specified signal values are inputted;

unspecified signal values are setto.unknown;

test templates are prepared defining the delay model for each logic gate;

the input circuit is parsed to generate an equivalent circuit consisting of 2-input logic gates; and

the 2-input logic gates are then configured

11. A method as claimed in any preceding claim in which a multi-valued logic is applied and in which n bits are used to represent a signal value at any instance in time with n being any arbitrarily chosen logic.

12. A method as claimed in claim 11 which an 8-valued logic is used where 000 represents logic 0,111 represents logic 1 and 001 to 110 represent arbitrarily defined other signal states.

13. A method as claimed in claim 11 or 12 in which the sequence of values on a logic gate is stored as a bit pattern forming a unique word in the associative memory mechanism (1a, 1b).

14. A method as claimed in any preceding claim in which there is stored a record of all values that a logic gate has acquired for the units of delay of the longest delay in the circuit.

15. A parallel processor adapted for a parallel processing method of circuit logic simulation (APPLES) comprising representing signals on a line over a time period as a bit sequence, evaluating the output of any logic gate including an evaluation of any inherent delay by a comparison between the bit sequences of the inputs of the logic gate to a predetermined series of bit patterns and in which those logic gates whose outputs have changed over the time period are identified during the evaluation of the gate outputs as real gate changes and only those real gate changes are propagated to fan out gates and in which the control of the method is carried out in an associative memory mechanism (1a, 1b) which stores in word form a history of gate input signals, a word corresponding to a particular wire and being associated with a gate type, by compiling a hit list register of logic gate state changes and using a multiple response resolver (7) forming part of the associative memory mechanism (1 a, 1 b) which generates an address for each hit, and then scans and transfers the results on the hit list to an output register for subsequent use, the processor comprising:-

a main processor (30);

an associative memory mechanism (1a, 1b) comprising associative array 1a and associative array 1b, the associative memory mechanism including a response

including a response resolver (7);

input value register bank (2);

test result register bank (4);

group result register bank (5);

group test hit list (6), the group test hit list feeding the response resolver; and

address register 9;

**characterised in that** the associative memory mechanism (1a, 1b) comprises:-

a plurality of separate associative sub-registers, each for the storage in word form of a history of gate input signals, one type of logic gate being allocated to each associative sub-register, and

a plurality of separate additional sub-registers associated with each associative sub-register whereby gate evaluations and tests can be carried out in parallel on each associative sub-register.

**16.** A processor as claimed in claim 15, in which the additional sub-registers comprise an input sub-register, a mask sub-register and a scan sub-register.

**17.** A processor as claimed in claim 16, in which the scan sub-registers are connected to an output register.


**Patentansprüche**

**1.** Parallelverarbeitungsverfahren für Schaltungslogiksimulation, das die folgenden Schritte umfasst: Darstellen von Signalen auf einer Linie über eine Zeitperiode als eine Bitsequenz, Beurteilen des Ausgangs eines Logikgatters einschließlich einer Beurteilung einer inhärenten Verzögerung mittels eines Vergleichs zwischen den Bitsequenzen der Eingänge des Logikgatters mit einer vorbestimmten Serie von Bitmustern, wobei diejenigen Logikgatter, deren Ausgänge sich über die Zeitperiode geändert haben, während der Beurteilung der Gatterausgänge als echte Gatteränderungen identifiziert werden, und nur diese echten Gatteränderungen zu den Fan-out-Gates dieser Logikgatter propagiert werden,
wobei die Steuerung des Verfahrens in einem assoziativen Speichermechanismus (1a, 1b) erfolgt, der in Wortform eine Historie von Gattereingangssignalen speichert,
wobei ein Wort einer bestimmten Leitung entspricht und mit einem Gattertyp assoziiert ist, indem ein Hitlistenregister von Logikgatter-Statusänderungen kompiliert und ein Multiple-Response-Resolver (7) benutzt wird, der einen Teil des assoziativen Speichermechanismus (1a, 1b) bildet, der eine Adresse für jeden Hit erzeugt, und dann die Ergebnisse auf der Hitliste scant und sie zu einem Ausgaberegister für die nachfolgende Verwendung überträgt, **dadurch gekennzeichnet, dass** das assoziative Register (1b) in separate kleinere assoziative Subregister unterteilt wird, wobei jedem assoziativen Subregister ein Logikgattertyp zugeordnet ist, wobei mit jedem assoziativen Subregister entsprechende Subregister verbunden sind, so dass Gatterbeurteilungen und Tests parallel auf jedem assoziativen Subregister durchgeführt werden.

**2.** Verfahren nach Anspruch 1, in dem jede Verzögerung als Verzögerungswort in einem assoziativen Speicher (1b) gespeichert wird, der einen Teil des assoziativen Speichermechanismus (1a, 1b) bildet, wobei:

die Länge des Verzögerungswortes bestimmt wird; und
wenn die Verzögerungswortbreite die Wortbreite im assoziativen Register (1b) überschreitet:

die Anzahl der ganzzahligen Vielfachen der in dem Verzögerungswort enthaltenen Registerwortbreite als

**EP 1 192 570 B1**

Gatterstatus berechnet wird;

der Gatterstatus in einem weiteren Statusregister (1a) gespeichert wird;

der Rest von der Berechnung in dem assoziativen Register (1b) mit denjenigen Verzögerungswörtern gespeichert wird, deren Breiten die Wortbreite des assoziativen Registers nicht überschritten; und

nach Beginn des Zählens des assoziativen Registers:

das Statusregister (1a) für das Verzögerungswort konsultiert wird, das in das Statusregister eingegeben wurde, und der Rest für diese Zahl des assoziativen Registers ignoriert wird;

am Ende des Zählens des assoziativen Registers das Statusregister aktualisiert wird; und

das Zählen fortgesetzt wird, bis der Rest das noch nötige Zählen repräsentiert.

3. Verfahren nach Anspruch 1 oder 2, bei dem die Hitliste in eine Mehrzahl von separaten kleineren Hitlisten segmentiert wird, wobei jede mit einem separaten Scan-Register verbunden ist und in dem jedes Scan-Register parallel betrieben wird, um die Ergebnisse zum Ausgangsregister zu übertragen.

4. Verfahren nach einem der Ansprüche 1 bis 3, in dem jedes Leitungssignal zu einem Ziellogikgatter als eine Mehrzahl von Bits gespeichert wird, die jeweils eine Verzögerung von einer Zeitperiode repräsentieren, wobei die Summenbits die Verzögerung zwischen Signalausgang zu dem und Empfang durch das Ziellogikgatter repräsentieren und in dem die inhärente Verzögerung jedes Logikgatters auf dieselbe Weise repräsentiert wird.

5. Verfahren nach einem der Ansprüche 1 oder 4, bei dem jedes assoziative Subregister zum Bilden einer Hitliste verwendet wird, die mit einem entsprechenden separaten Scan-Register verbunden ist.

6. Verfahren nach einem der Ansprüche 1 bis 5, bei dem dort, wo die Zahl des einen Logikgattertyps einen vorbestimmten Wert überschreitet, mehr als ein Subregister verwendet wird.

7. Verfahren nach einem der Ansprüche 3 bis 6, in dem die Scan-Register durch Ausnahmelogik unter Verwendung eines OR-Gatters gesteuert werden, wodurch der Scan für jedes Register dann terminiert wird, wenn das OR-Gatter seinen Status geändert hat und so keine weiteren Übereinstimmungen anzeigt.

8. Verfahren nach Anspruch 7, bei dem der Scan durch sequentielles Zählen durch die Hitliste erfolgt und die folgenden Schritte ausgeführt werden:

Prüfen, ob das Bit gesetzt ist, so dass ein Hit angezeigt wird;

wenn ein Hit vorliegt, Ermitteln der Adresse, die von diesem Hit bewirkt wird;

Speichern der Adresse;

Löschen des Bits in der Hitliste;

Bewegen zur nächsten Position in der Hitliste; und

Wiederholen der obigen Schritte, bis die Hitliste gelöscht ist.

9. Verfahren nach einem der vorherigen Ansprüche, in dem jedes Leitungssignal zu einem Ziellogikgatter als eine Mehrzahl von Bits gespeichert wird, die jeweils eine Verzögerung von einer Zeitperiode repräsentieren, wobei die Summenbits die Verzögerung zwischen dem Signalausgang zu dem und Empfang durch das Ziellogikgatter repräsentieren.

10. Verfahren nach einem der vorherigen Ansprüche, in dem eine Initialisierungsphase besteht, in der:

vorgegebene Signalwerte eingegeben werden;

unvorgegebene Signalwerte auf unbekannt gesetzt werden;

Testschablonen vorbereitet werden, die das Verzögerungsmodell für jedes Logikgatter definieren;

die Eingangsschaltung geparst wird, um eine äquivalente Schaltung zu erzeugen, die aus 2-Eingangs-Logikgattern besteht; und

die 2-Eingangs-Logikgatter dann konfiguriert werden.

11. Verfahren nach einem der vorherigen Ansprüche, in dem eine mehrwertige Logik angewendet wird und in dem n Bits zum Darstellen eines Signalwertes zu jedem Zeitpunkt verwendet werden, wobei n eine beliebige willkürlich gewählte Logik ist.

46

**12.** Verfahren nach Anspruch 11, bei dem eine 8-wertige Logik verwendet wird, wobei 000 Logik 0 repräsentiert, 111 Logik 1 repräsentiert und 001 bis 110 willkürlich definierte andere Signalzustände repräsentieren.

**13.** Verfahren nach Anspruch 11 oder 12, bei dem die Sequenz von Werten auf einem Logikgatter als Bitmuster gespeichert wird, das ein eindeutiges Wort in dem assoziativen Speichermechanismus (1a, 1b) bildet.

**14.** Verfahren nach einem der vorherigen Ansprüche, bei dem ein Datensatz aller Werte gespeichert ist, die ein Logikgatter für die Verzögerungseinheiten der längsten Verzögerung in der Schaltung erworben hat.

**15.** Parallelprozessor für ein paralleles Verarbeitungsverfahren von Schaltungslogiksimulation (APPLES), das die folgenden Schritte umfasst: Darstellen von Signalen auf einer Linie über eine Zeitperiode als eine Bitsequenz, Beurteilen des Ausgangs eines Logikgatters einschließlich einer Beurteilung einer inhärenten Verzögerung mittels eines Vergleichs zwischen den Bitsequenzen der Eingänge des Logikgatters mit einer vorbestimmten Serie von Bitmustern, wobei diejenigen Logikgatter, deren Ausgänge sich über die Zeitperiode geändert haben, während der Beurteilung der Gatterausgänge als echte Gatteränderungen identifiziert werden, und nur diese echten Gatteränderungen zu Fan-out-Gates propagiert werden, wobei die Steuerung des Verfahrens in einem assoziativen Speichermechanismus (1a, 1b) erfolgt, der in Wortform eine Historie von Gattereingangssignalen speichert, wobei ein Wort einer bestimmten Leitung entspricht und mit einem Gattertyp assoziiert ist, indem ein Hitlistenregister von Logikgatter-Statusänderungen kompiliert und ein Multiple-Response-Resolver (7) benutzt wird, der einen Teil des assoziativen Speichermechanismus (1a, 1b) bildet, der eine Adresse für jeden Hit erzeugt, und dann die Ergebnisse auf der Hitliste scant und sie zu einem Ausgaberegister für die nachfolgende Verwendung überträgt, wobei der Prozessor Folgendes umfasst:

einen Hauptprozessor (30);
einen assoziativen Speichermechanismus (1a, 1b), der eine assoziative Array 1a und eine assoziative Array 1b umfasst, wobei der assoziative Speichermechanismus Folgendes umfasst:

einen Response-Resolver (7);
eine Eingangswert-Registerbank (2);
eine Testergebnis-Registerbank (4);
eine Gruppenergebnis-Registerbank (5);
eine Gruppentesthitliste (6), wobei die Gruppentesthitliste den Response-Resolver speist; und
Adressregister 9;

**dadurch gekennzeichnet, dass** der assoziative Speichermechanismus (1a, 1b) Folgendes umfasst:

eine Mehrzahl von separaten assoziativen Subregistern, jeweils zum Speichern einer Historie von Gattereingabesignalen in Wortform, wobei jedem assoziativen Subregister ein Logikgattertyp zugeordnet wird; und
eine Mehrzahl von separaten zusätzlichen Subregistern, die mit jedem assoziativen Subregister assoziiert sind, so dass Gatterbeurteilungen und Tests parallel auf jedem assoziativen Subregister durchgeführt werden können.

**16.** Prozessor nach Anspruch 15, in dem die zusätzlichen Subregister ein Eingangssubregister, ein Maskensubregister und ein Scansubregister umfassen.

**17.** Prozessor nach Anspruch 16, in dem die Scansubregister mit einem Ausgaberegister verbunden sind.

**Revendications**

**1.** Procédé de traitement parallèle de simulation logique de circuit comprenant la représentation de signaux sur une ligne durant une période de temps sous forme de séquence binaire, l'évaluation de la sortie de toute porte logique comprenant une évaluation de tout retard inhérent par une comparaison des séquences binaires des entrées de la porte logique à une série prédéterminée de configurations binaires et dans lequel les portes logiques dont les sorties ont changé durant la période de temps sont identifiées durant l'évaluation des sorties de portes en tant que changements de porte réels et seuls les changements de porte réels sont propagés jusqu'aux portes de sortance de ces portes logiques,
la commande du procédé est effectuée dans un mécanisme de mémoire associative (1a, 1b) qui mémorise sous forme de mots un historique des signaux d'entrée de porte, un mot correspondant à un fil particulier et étant associé à un type de porte, en compilant un registre de liste d'occurrences de changements d'états de portes logiques et en utilisant un résolveur de réponses multiples (7) faisant partie du mécanisme de mémoire associative (1a, 1b) qui génère une adresse pour chaque occurrence, puis balaye et transfère les résultats sur la liste d'occurrence vers un registre de sortie en vue de leur utilisation ultérieure **caractérisé en ce que** le registre associatif (1b) est divisé en sous-registres associatifs plus petits séparés, un type de porte logique étant attribué à chaque sous-registre associatif, à chacun des sous-registres associatifs étant reliés des sous-registres correspondants par lesquels des évaluations et tests de portes sur chaque sous-registre associatif sont effectués en parallèle.

2. Procédé selon la revendication 1, dans lequel chaque retard est mémorisé sous forme de mot de retard dans une mémoire associative (1b) faisant partie du mécanisme de mémoire associative (1a, 1b) dans lequel :

> la longueur du mot de retard est déterminée ; et
> si la largeur du mot de retard dépasse la largeur de mot du registre associatif (1b) :
> le nombre de multiples entiers de la largeur de mot de registre contenu dans le mot de retard est calculé en tant qu'état de porte ;
> l'état de porte est mémorisé dans un autre registre d'état (1a) ;
> le reste du calcul est mémorisé dans le registre associatif (1b) avec les mots de retard dont les largeurs ne dépassaient pas la largeur de mot du registre associatif ; et
> au commencement du compte du registre associatif :
>
> > le registre d'état (1a) est consulté à la recherche du mot de retard entré dans le registre d'état et le reste est ignoré pour ce compte du registre associatif ;
> > à la fm du compte du registre associatif, le registre d'état est mis à jour ; et
> > le compte continue jusqu'à ce que le reste représente le compte encore nécessaire.

3. Procédé selon la revendication 1 ou 2, dans lequel la liste d'occurrences est segmentée en une pluralité de listes d'occurrences plus petites séparées, chacune connectée à un registre de balayage séparé et dans lequel chaque registre de balayage est actionné en parallèle afin de transférer les résultats au registre de sortie.

4. Procédé selon l'une quelconque des revendications 1 à 3, dans lequel chaque signal de ligne vers une porte logique cible est mémorisé sous forme de pluralité de bits représentant chacun un retard d'une période de temps, les bits groupés représentant le retard entre le signal sorti vers la porte logique cible et sa réception par celle-ci et dans lequel le retard inhérent de chaque porte logique est représenté de la même manière.

5. Procédé selon l'une quelconque des revendications 1 ou 4, dans lequel chaque sous-registre associatif est utilisé pour former une liste d'occurrences reliée à un registre de balayage séparé correspondant.

6. Procédé selon l'une quelconque des revendications 1 à 5, dans lequel lorsque le nombre d'un type de porte logique dépasse un nombre prédéterminé plus d'un sous-registre est utilisé.

7. Procédé selon l'une quelconque des revendications 3 à 6, dans lequel les registres de balayage sont commandés par une logique d'exception utilisant une porte OU de telle sorte que le balayage de chaque registre prenne fin lorsque la porte OU change d'état indiquant alors aucune autre correspondance.

8. Procédé selon la revendication 7, dans lequel le balayage est effectué par un compte séquentiel de la liste d'occurrences et les étapes suivantes sont effectuées :

> vérification si le bit est mis sur un, indiquant une occurrence ;
> en cas d'occurrence, détermination de l'adresse effectuée par cette occurrence ;
> mémorisation de l'adresse ;
> remise à zéro du bit dans la liste d'occurrences ;
> passage à la position suivante dans la liste d'occurrences ; et
> répétition des étapes ci-dessus jusqu'à ce que la liste d'occurrences soit remise à zéro.

9. Procédé selon l'une quelconque des revendications précédentes, dans lequel chaque signal de ligne vers une porte logique cible est mémorisé sous forme de pluralité de bits représentant chacune un retard d'une période de temps, les bits groupés représentant le retard entre le signal sorti vers la porte logique cible et sa réception par celle-ci.

10. Procédé selon l'une quelconque des revendications précédentes, dans lequel existe une phase d'initialisation durant laquelle :

des valeurs de signal spécifiées sont entrées ;
des valeurs de signal non spécifiées sont réglées sur une valeur inconnue ;
des modèles de test définissant le modèle de retard de chaque porte logique sont préparés ;
le circuit d'entrée est analysé afin de générer un circuit équivalent consistant en portes logiques à 2 entrées ; et
les portes logiques à 2 entrées sont alors configurées.

11. Procédé selon l'une quelconque des revendications précédentes, dans lequel une logique à valeurs multiples est appliquée et dans lequel n bits sont utilisés pour représenter une valeur de signal à n'importe quel moment dans le temps, n étant n'importe quelle logique choisie arbitrairement.

12. Procédé selon la revendication 11, dans lequel une logique à 8 valeurs est utilisée, où 000 représente un 0 logique, 111 représente un 1 logique et 001 à 110 représentent des autres états de signal définis arbitrairement.

13. Procédé selon la revendication 11 ou 12, dans lequel la séquence de valeurs sur une porte logique est mémorisée sous forme de configuration binaire formant un mot unique dans le mécanisme de mémoire associative (1a, 1b).

14. Procédé selon l'une quelconque des revendications précédentes, dans lequel est mémorisé un enregistrement de toutes les valeurs qu'une porte logique a acquises pour les unités de retard du plus long retard dans le circuit.

15. Processeur parallèle adapté pour un procédé de traitement parallèle de simulation logique de circuit (APPLES) comprenant la représentation de signaux sur une ligne durant une période de temps sous forme de séquence binaire, l'évaluation de la sortie de toute porte logique comprenant une évaluation de tout retard inhérent par une comparaison des séquences binaires des entrées de la porte logique à une série prédéterminée de configurations binaires et dans lequel les portes logiques dont les sorties ont changé durant la période de temps sont identifiées durant l'évaluation des sorties de portes en tant que changements de porte réels et seuls les changements de porte réels sont propagés jusqu'à des portes de sortance et dans lequel la commande du procédé est effectuée dans un mécanisme de mémoire associative (1a, 1b) qui mémorise sous forme de mots un historique des signaux d'entrée de porte, un mot correspondant à un fil particulier et étant associé à un type de porte, en compilant un registre de liste d'occurrences de changements d'états de portes logiques et en utilisant un résolveur de réponses multiples (7) faisant partie du mécanisme de mémoire associative (1a, 1b) qui génère une adresse pour chaque occurrence, puis balaye et transfère les résultats sur la liste d'occurrences vers un registre de sortie en vue de leur utilisation ultérieure,

le processeur comprenant
un processeur principal (30) ;
un mécanisme de mémoire associative (1a, 1b) comprenant une matrice associative 1a et une matrice associative 1b, le mécanisme de mémoire associative comportant un résolveur de réponses (7) ;
un bloc de registres de valeurs d'entrée (2) ;
un bloc de registres de résultats de test (4) ;
un bloc de registres de résultats de groupe (5) ;
une liste d'occurrences de test de groupe (6), la liste d'occurrences de test de groupe alimentant le résolveur de réponses, et
un registre d'adresses 9 ;

**caractérisé en ce que** le mécanisme de mémoire associative (1a , 1b) comprend :

une pluralité de sous-registres associatifs séparés, servant chacun à la mémorisation sous forme de mots d'un historique de signaux d'entrée de porte, un type de porte logique étant attribué à chaque sous-registre associatif ; et
une pluralité de sous-registres supplémentaires séparés associés à chaque sous-registre associatif par lesquels des évaluations et tests de portes sur chaque sous-registre associatif peuvent être effectués en parallèle.

16. Processeur selon la revendication 15, dans lequel les sous-registres supplémentaires comprennent un sous-registre d'entrée, un sous-registre de masque et un sous-registre de balayage.

17. Processeur selon la revendication 16, dans lequel les sous-registres de balayage sont reliés à un registre de sortie.

_Fig. 1_

Scan Group-test Hit
list and update fan-
out lists

[Scan mechanism]

Apply Gate type/delay model
Test Patterns to Array 1b

Combine Test-results
register Bank results into
Group-result register Bank

Search Group-result
register Bank for Test
successes

Initialisation

[5-10 cycles]

[1 cycle]

Store results
in Test-result register Bank

[5-10 cycles]

One simulated time interval for one
gate type and output transition

## *Fig. 3*

111 | 111

000 | 111

tc          tc-1

$t_1$:  000           — Search_reg 1b        ANY     Grp_rslt_imp_reg(1)=1
        111    000 Mask_reg 1b       ⟶     Grp_rslt_mask_reg(1)=1
                                                    Rslt_act_reg(1)=0

$t_2$:  —      111 Search_reg 1b       NONE    Grp_rslt_imp_reg(2)=0
        000    000 Mask_reg 1b        ⟶     Grp_rslt_mask_reg(2)=1
                                                    Rslt_act_reg(2)=0

## *Fig. 4*

*Any: Result-activator register[i]=0*
*Group-result Input register[i]=1*

*Both: Result-activator register[i]=1*
*Group-result Input register[i]=1*

*None: Result-activator register[i]=0*
*Group-result Input register[i]=0*

*Result-activator register[i]=0; OR operation between i th test bits of gate*
*input pairs Test-result register*

*Result-activator register[i]=1; AND operation between i th test bits of gate*
*input pairs Test-result register*

## *Fig. 5*

|  | **Associative Array 1b** | **Test-result register Bank** | **Group result Register Bank** |  |
|---|---|---|---|---|
| **Gate A** | 000000x<br>111111x | 11xxx x<br>00xxxx | 11xxx x | No Hits |
| **Gate B** | 111111x<br>000111x | 00xxx x<br>10xxxx | 10xxx x | Hit |
|  | [   ] | [ 00xxx ] | [ 100000 ] |  |
|  | *Array 1b Input-register* | *Result-activator register* | *Group result Register* |  |

*Search: T , T ⟶ Combine ⟶ Search*

## *Fig. 6*

*Ambiguous Delay model (2 bits per time unit), delay$_{ab}$ = M units,*

*Delay$_{ab}$ = N units, AND transition to logic '0'*

*First stage: Transition to unknown state (i.e. Output assigned '11').*

Test T1: Search-reg 1b =    xxx...1 1x....x  
      Mask-reg 1b =   0000...1 110....0

           2.M$^{th}$ bit position

Test T2: Search-reg 1b =    xxx....00xx.....x  
      Mask-reg 1b =   000....11 00....0

           2.(M+1°)this position

Condition: Any input satisfying T1 and None satisfying T2  
Then:  
      Result-activator register      =00xxx  
      Group-result input register    =10xxx

*Second Stage: Transition from Unknown state to logic 0*

Test T1: Search-reg 1b =    xxx......11x.....x  
      Mask-reg   1b =   0000...11 00...0

           2.N$^{th}$ bit position

Test T2: Search-reg 1b =    xxx......00xx..x  
      Mask-reg   1b =   000.....1100...0

           2.(N+1°)bit position

Condition: Any input satisfying T1 and None satisfying T2  
Then:  
      Result-activator register      =00xxx  
      Group-result input register    =10xxx

*Hazard Detection: AND/OR gates. N-unit Pure Delay*

Test T1: Search-reg 1b =    xxx......11x.....x  
      Mask-reg   1b =   0000...11 00...0

           N$^{th}$ bit position

Test T2: Search-reg 1b =    xxxxx..........10xx..x  
      Mask-reg   1b =   000000....110...0

           N+1° bit position

Condition: Any input satisfying T1 and None satisfying T2  
Then:  
      Result-activator register      =00xxx  
      Group-result input register    =11xxx

# *Fig. 7*

*Fig. 8*

Fig. 9

EP 1 192 570 B1

Fig. 10

EP 1 192 570 B1